# EUROPEAN PATENT APPLICATION

(11) **EP 4 629 795 A1**
(43) Date of publication of application: **08.10.2025**
(21) Application number: 25167412.3
(22) Date of filing: 31.03.2025
(51) Int. Cl.: H10K 59/121, G09G 3/3233, G09G 3/3258, H10K 59/126, H10K 59/131

(54) **DISPLAY PANEL AND ELECTRONIC DEVICE**

(30) Priority: 03.04.2024 KR 20240045507
(71) Applicant: Samsung Display Co., Ltd., Yongin-si, Gyeonggi-do 17113 (KR)
(72) Inventor: Lim, Chaeyeol, 17113 Yongin-si, Gyeonggi-do (KR); Jang, Soyoung, 17113 Yongin-si, Gyeonggi-do (KR); Cho, Youngjin, 17113 Yongin-si, Gyeonggi-do (KR); Jo, Eunbyul, 17113 Yongin-si, Gyeonggi-do (KR)
(74) Representative: Gulde & Partner

(57) **Abstract**

A display panel includes: first and second pixel circuits adjacent to each other in a first direction; a first light-emitting diode, LED, electrically connected to the first pixel circuit; a second LED electrically connected to the second pixel circuit; a first horizontal voltage line extending in the first direction, and electrically connected to a semiconductor layer of a first transistor; a second horizontal voltage line extending in the first direction, and electrically connected to a semiconductor layer of a second transistor; and a first gate line extending in the first direction, and electrically connected to each of a gate electrode of the first transistor of the first pixel circuit and a gate electrode of the second transistor of the second pixel circuit. The first horizontal voltage line and the second horizontal voltage line are at different layers from each other, and overlap with each other in a plan view.

## Description

### BACKGROUND

### 1. Field

Aspects of one or more embodiments of the present disclosure relate to display panel and an electronic device including the same.

### 2. Description of the Related Art

In recent years, uses of display devices have diversified. In addition, as the range of use of the display devices has widened, demands for high-resolution display devices have increased. In order to manufacture high-quality display devices, it may be desirable to arrange electronic elements of various configurations in a narrow area.

The above information disclosed in this Background section is for enhancement of understanding of the background of the present disclosure, and therefore, it may contain information that does not constitute prior art.

### SUMMARY

One or more embodiments of the present disclosure may be directed to various structures of display devices and electronic device.

However, the present disclosure is not limited to the above aspects and features. Additional aspects and features will be set forth, in part, in the description that follows, and in part, may be apparent from the description, or may be learned by practicing one or more of the presented embodiments of the present disclosure.

According to one or more embodiments of the present disclosure, a display panel includes: a first pixel circuit and a second pixel circuit adjacent to each other in a first direction, each of the first and second pixel circuits including a driving transistor and a first capacitor on a substrate; a first light-emitting diode electrically connected to the first pixel circuit; a second light-emitting diode electrically connected to the second pixel circuit; a first horizontal voltage line extending in the first direction, and electrically connected to a semiconductor layer of a first transistor, the semiconductor layer of the first transistor being electrically connected to the driving transistor of the first pixel circuit and a pixel electrode of the first light-emitting diode; a second horizontal voltage line extending in the first direction, and electrically connected to a semiconductor layer of a second transistor, the semiconductor layer of the second transistor being electrically connected to the driving transistor of the second pixel circuit and a pixel electrode of the second light-emitting diode; and a first gate line extending in the first direction, and electrically connected to each of a gate electrode of the first transistor of the first pixel circuit and a gate electrode of the second transistor of the second pixel circuit. The first horizontal voltage line and the second horizontal voltage line are at different layers from each other, and overlap with each other in a plan view.

In an embodiment, the second horizontal voltage line may be at a same layer as that of the first gate line.

In an embodiment, the display panel may further include a bottom metal layer between an upper surface of the substrate and the driving transistor of the first pixel circuit, and between the upper surface of the substrate and the driving transistor of the second pixel circuit, the bottom metal layer including: a first main portion overlapping with a channel region of the driving transistor of the first pixel circuit; a second main portion overlapping with a channel region of the driving transistor of the second pixel circuit; a first branch portion extending in the first direction to connect the first main portion and the second main portion to each other; and second branch portions connected to the first main portion and the second main portion, respectively, and extending in a second direction crossing the first direction.

In an embodiment, in the plan view, the second branch portions may cross the first horizontal voltage line and the second horizontal voltage line.

In an embodiment, the display panel may further include a horizontal driving voltage line extending in the first direction, and overlapping with the driving transistor of the first pixel circuit and the driving transistor of the second pixel circuit. The horizontal driving voltage line may overlap with the first branch portion.

In an embodiment, each of the first pixel circuit and the second pixel circuit may further include a compensation transistor electrically connected to the driving transistor, and including a compensation semiconductor layer and a compensation gate electrode. The first horizontal voltage line may be located at a same layer as that of the compensation gate electrode of the compensation transistor.

In an embodiment, the display panel may further include a first connection electrode electrically connecting the compensation semiconductor layer of the compensation transistor of the first pixel circuit and a driving gate electrode of the driving transistor of the first pixel circuit to each other, and the first connection electrode may overlap with one of the second branch portions of the bottom metal layer.

In an embodiment, the display panel may further include a driving voltage line extending in the second direction to pass through the first pixel circuit.

In an embodiment, the driving voltage line may overlap with the first connection electrode and the one of the second branch portions of the bottom metal layer corresponding to the first pixel circuit.

In an embodiment, in the plan view, the driving voltage line may overlap with the compensation gate electrode of the compensation transistor of the first pixel circuit.

In an embodiment, the first pixel circuit may further include a first initialization transistor including a first initialization semiconductor layer and a first initialization gate electrode, the first initialization semiconductor layer being integrally connected to the compensation semiconductor layer of the compensation transistor, and the driving voltage line may overlap with the first initialization gate electrode.

In an embodiment, the display panel may further include a third pixel circuit located on an opposite side of the first pixel circuit with respect to the second pixel circuit, and a first spaced distance between the driving transistor of the second pixel circuit and a driving transistor of the third pixel circuit may be greater than a second spaced distance between the driving transistor of the second pixel circuit and the driving transistor of the first pixel circuit.

In an embodiment, a planar shape of a channel region of the driving transistor of the third pixel circuit may be different from at least one of a planar shape of a channel region of the driving transistor of the second pixel circuit or a planar shape of a channel region of the driving transistor of the first pixel circuit.

In an embodiment, the third pixel circuit may further include a third transistor electrically connected to the driving transistor of the third pixel circuit, a pixel electrode of a third light-emitting diode may be electrically connected to the third pixel circuit, and the second horizontal voltage line may be electrically connected to the third transistor of the third pixel circuit.

In an embodiment, the third pixel circuit may further include a third transistor electrically connected to the driving transistor of the third pixel circuit, a pixel electrode of a third light-emitting diode may be electrically connected to the third pixel circuit, and a third horizontal voltage line electrically connected to the third transistor of the third pixel circuit may be located at a layer different from those of the first horizontal voltage line and the second horizontal voltage line, and may overlap with the first horizontal voltage line and the second horizontal voltage line.

In an embodiment, the display panel may further include a first vertical voltage line extending in a second direction crossing the first direction, and passing through a separation space having the first spaced distance between the second pixel circuit and the third pixel circuit. The first horizontal voltage line may be electrically connected to the first vertical voltage line.

In an embodiment, the first horizontal voltage line may further include a bridge portion protruding from the first horizontal voltage line, and the bridge portion may be connected to the first vertical voltage line.

In an embodiment, the display panel may further include a connection electrode located above the bridge portion and below the first vertical voltage line, and the bridge portion and the first vertical voltage line may be electrically connected to each other through the connection electrode.

In an embodiment, the first horizontal voltage line may be electrically connected to the first vertical voltage line through a bridge portion that may be located at a layer different from that of the first horizontal voltage line.

In an embodiment, each of the first pixel circuit and the second pixel circuit may further include a data write transistor electrically connected to the driving transistor and the first capacitor, and in the plan view, a first data line electrically connected to the data write transistor of the first pixel circuit and a second data line electrically connected to the data write transistor of the second pixel circuit may have different shapes from each other.According to one or more embodiments of the present disclosure, an electronic device comprises a display panel according any one embodiment above.

In an embodiment, the electronic device comprises a mobile phone, a laptop, a tablet personal computer (PC), a smartphone, a mobile communication terminal, an electronic notebook, an electronic book, a portable multimedia player (PMP), a navigation device, an ultra mobile PC, a television, a monitor, a smart watch, a watch phone, a glasses-type display, a head-mounted display (HMD), or an automotive display device.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a plan view schematically illustrating a display device, according to an embodiment;
FIG. 2 is a block diagram schematically illustrating a display device, according to an embodiment;
FIG. 3 is an equivalent circuit diagram illustrating one light-emitting diode and a pixel circuit arranged in a display device, according to an embodiment;
FIG. 4 is a cross-sectional view illustrating a part of a display area of a display device, according to an embodiment;
FIG. 5 is a plan view schematically illustrating some lines arranged in a display area of a display device, according to an embodiment;
FIG. 6 is a plan view of first to third pixel circuits of a display device, according to an embodiment;
FIGS. 7-15 are plan views showing a method of forming the first to third pixel circuits shown in FIG. 6;
FIG. 16 is a plan view schematically illustrating second initialization horizontal voltage lines passing through first to third pixel circuits of a display device, according to an embodiment;
FIG. 17 is a cross-sectional view taken along the lines A-A' and B-B' of FIG. 16;
FIG. 18 is a plan view schematically illustrating second initialization horizontal voltage lines passing through first to third pixel circuits of a display device, according to an embodiment;
FIG. 19 is a cross-sectional view taken along the line C-C' of FIG. 18; and
FIG. 20 is a plan view showing an electrical connection between a second initialization horizontal voltage line and a second initialization vertical voltage line of a display device, according to an embodiment.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively. Also, the term "exemplary" is intended to refer to an example or illustration.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

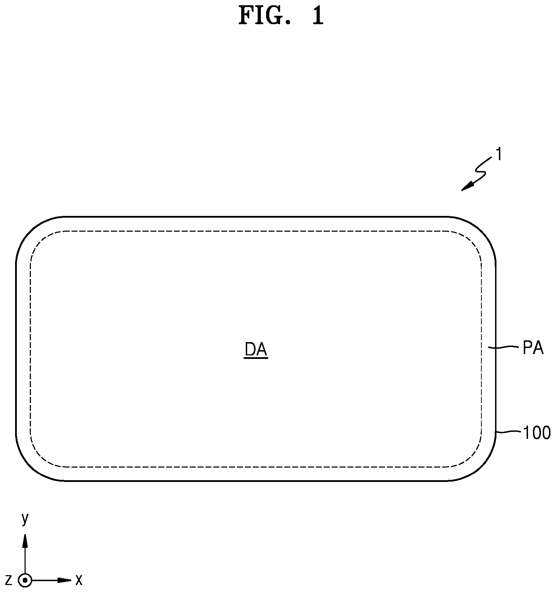

FIG. 1 is a plan view schematically illustrating a display device 1, according to an embodiment.

Referring to FIG. 1, the display device (e.g., display or display panel) 1 may include a display area DA on which an image is displayed, and a peripheral area PA outside the display area DA. The display area DA may be entirely or substantially entire surrounded (e.g., around a periphery thereof) by the peripheral area PA.

In a plan view, the display area DA may have a rectangular shape or substantially rectangular shape with rounded corners. In another embodiment, the display area DA may have any suitable polygonal shape, such as triangle shapes, quadrate shapes, pentagon shapes, or hexagon shapes. In another embodiment, the display area DA may have a circular shape, an elliptical shape, an irregular shape, or the like.

The display device 1 illustrated in FIG. 1 may be a device that displays moving images and/or still images, and may be used for various suitable portable electronic device (e.g., an electronic apparatus, or a consumer product), such as a mobile phone, a laptop, a tablet personal computer (PC), a smartphone, a mobile communication terminal, an electronic notebook, an electronic book, a portable multimedia player (PMP), a navigation device, or an ultra mobile PC. As another example, the display device 1 may be used for televisions, monitors, billboards, or Internet of Things (IoT) devices. As another example, the display device 1 may be used for various suitable wearable electronic apparatus (e.g., electronic devices), such as a smart watch, a watch phone, a glasses-type display, or a head-mounted display (HMD). In addition, the display device 1 according to an embodiment may be used for an instrument panel of a vehicle, a center information display (CID) disposed on a center fascia or a dashboard of a vehicle, a room mirror display replacing the side-view mirrors of a vehicle, or a display disposed on the rear surface of a front seat for entertainment for the backseat of a vehicle.

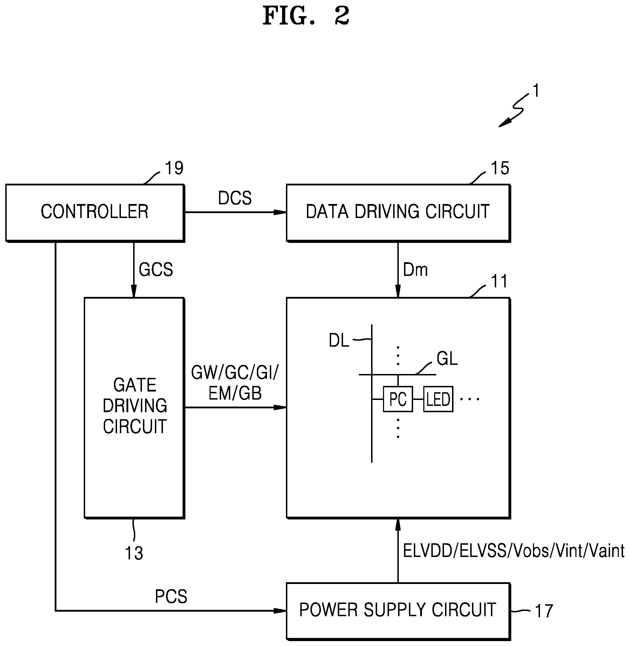

FIG. 2 is a block diagram schematically illustrating the display device 1, according to an embodiment.

Referring to FIGS. 1 and 2, the display device 1 according to an embodiment may include a pixel unit (e.g., a pixel layer, or a display layer) 11, a gate driving unit (e.g., a gate driver or a gate driving circuit) 13, a data driving unit (e.g., a data driver or a data driving circuit) 15, a power supply circuit 17, and a controller 19.

The pixel unit 11 may include a plurality of pixels in the display area DA (e.g., see FIG. 1). The plurality of pixels may be arranged in various suitable shapes, such as a stripe arrangement, a diamond arrangement (e.g., a PENTILE^{®} arrangement, PENTILE^{®} being a duly registered trademark of Samsung Display Co., Ltd.), or a mosaic arrangement, and may implement an image. Each of the pixels may emit light through a light-emitting diode LED. Each light-emitting diode LED may be electrically connected to a corresponding pixel circuit PC. Each pixel circuit PC may be electrically connected to a corresponding gate line GL and a corresponding data line DL, and may include a plurality of transistors and at least one capacitor.

In the peripheral area PA (e.g., see FIG. 1), various conductive lines to transfer an electrical signal to be applied to the display area DA (e.g., see FIG. 1), peripheral circuits electrically connected to the pixel circuits PC, or pads to which a printed circuit board or driver integrated circuit (IC) chip is attached may be positioned. For example, the gate driving unit 13, the data driving unit 15, the power supply circuit 17, and the controller 19 may be provided in the peripheral area PA (e.g., see FIG. 1).

The gate driving unit 13 may be electrically connected to a plurality of gate lines GL. The gate driving unit 13 may generate a gate signal corresponding to a control signal GCS from the controller 19, and may sequentially supply the generated gate signal to the gate lines GL. The gate signal may be a gate control signal for controlling a turn-on or a turn-off of a transistor electrically connected to the gate line GL. The gate signal may be square wave signals including an on voltage at which a transistor may be turned on, and an off voltage at which the transistor may be turned off. In an embodiment, the on voltage may be a first-level voltage (e.g., a high-level voltage) or a second-level voltage (e.g., a low-level voltage).

In FIG. 2, any one pixel circuit PC is shown as being connected to one gate line GL. However, the present disclosure is not limited thereto, and any one pixel circuit PC may be connected to two or more gate lines GL. In this case, the gate driving unit 13 may supply, to the corresponding gate lines GL, two or more gate signals having different timings from each other at which the on voltage is applied to the corresponding gate lines GL. For example, the pixel circuit PC may be electrically connected to a plurality of gate lines GL, and the gate driving unit 13 may apply a scan signal GW, a first initialization control signal GI, a second initialization control signal GB, a compensation scan signal GC, and an emission control signal EM to the pixel circuit PC through the plurality of gate lines GL, respectively.

The data driving unit 15 may be connected to the plurality of data lines DL, and may supply a data signal Dm corresponding to a control signal DCS from the controller 19 to the data lines DL. The data signal Dm supplied to the data line DL may be provided to the pixel circuit PC. The data driving unit 15 may convert input image data having gray levels (e.g., grayscale values) input from the controller 19 into the data signal Dm in the form of a voltage or a current.

The power supply circuit 17 may generate voltages used for driving the pixel circuit PC and the light-emitting diode LED. The generated voltages may correspond to a control signal PCS from the controller 19. The power supply circuit 17 may generate a driving voltage ELVDD and a common voltage ELVSS, and may supply the generated driving voltage ELVDD and the generated common voltage ELVSS to the pixel circuit PC and the light-emitting diode LED, respectively. The driving voltage ELVDD may be a high-level voltage provided to a first electrode (e.g., a pixel electrode, an anode, and the like) of the light-emitting diode LED. The common voltage ELVSS may be a low-level voltage provided to a second electrode (e.g., an opposite electrode, a cathode, and the like) of the light-emitting diode LED. The power supply circuit 17 may generate and supply a bias voltage Vobs, a first initialization voltage Vint, and a second initialization voltage Vaint to the pixel circuit PC.

A voltage level of the driving voltage ELVDD may be higher than a voltage level of the common voltage ELVSS. Voltage levels of the first initialization voltage Vint and the second initialization voltage Vaint may be higher than the voltage level of the common voltage ELVSS. A voltage level of the bias voltage Vobs may be higher than the voltage level of the driving voltage ELVDD.

The controller 19 may generate the control signals GCS, DCS, and PCS based on signals received from the outside, and may supply the generated control signals GCS, DCS, and PCS to the gate driving unit 13, the data driving unit 15, and the power supply circuit 17. The control signal GCS output to the gate driving unit 13 may include a plurality of clock signals and a gate start signal. The control signal DCS output to the data driving unit 15 may include a source start signal and clock signals.

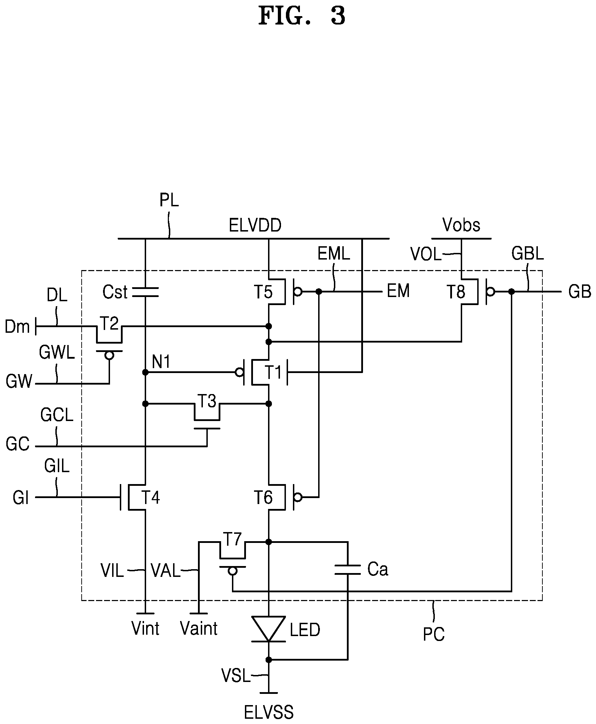

FIG. 3 is an equivalent circuit diagram illustrating one light-emitting diode LED and a pixel circuit PC arranged in a display device, according to an embodiment. However, the disclosure is not restricted thereto and also other circuits could be used.

Referring to FIG. 3, the pixel circuit PC may be connected to a plurality of gate lines, such as each of a scan line GWL, a first initialization control line GIL, a second initialization control line GBL (also referred to as "a first gate line"), a compensation scan line GCL, and an emission control line EML. The pixel circuit PC may receive the scan signal GW, the first initialization control signal GI, the second initialization control signal GB, the compensation scan signal GC, and the emission control signal EM. For example, the scan line GWL, the first initialization control line GIL, the second initialization control line GBL, the compensation scan line GCL, and the emission control line EML illustrated in FIG. 3 may be the gate lines connected to the pixel circuit PC in an i^{th} row (where i is a natural number greater than zero).

The pixel circuit PC may receive the data signal Dm through the data line DL. For example, the data line DL illustrated in FIG. 3 may be a signal line connected to the pixel circuit PC in a j^{th} column (where j is a natural number greater than zero).

The pixel circuit PC of the display device according to the present embodiment may be electrically connected to the light-emitting diode LED for emitting light of a desired color (e.g., a certain or predetermined color). The light-emitting diode LED may include a first electrode (e.g., a pixel electrode, an anode, or the like), a second electrode (e.g., an opposite electrode, a cathode, or the like), and an intermediate layer therebetween.

The pixel circuit PC may include a plurality of transistors T1, T2, T3, T4, T5, T6, T7, and T8, and capacitors Cst and Ca. The plurality of transistors T1, T2, T3, T4, T5, T6, T7, and T8 may include a driving transistor T1, a data write transistor T2, a compensation transistor T3, a first initialization transistor T4, an operation control transistor T5, an emission control transistor T6, a second initialization transistor T7, and a bias transistor T8. The capacitors Cst and Ca may include a first capacitor Cst and a second capacitor Ca.

In an embodiment, some of the plurality of transistors T1, T2, T3, T4, T5, T6, T7, and T8 may be P-channel metal-oxide-semiconductor field-effect transistors (MOSFETs) or PMOS transistors. The other remaining transistors may be N-type MOSFETs or NMOS transistors. For example, the driving transistor T1, the data write transistor T2, the operation control transistor T5, the emission control transistor T6, the second initialization transistor T7, and the bias transistor T8 from among the plurality of transistors T1, T2, T3, T4, T5, T6, T7, and T8 may be PMOS transistors, and the compensation transistor T3 and the first initialization transistor T4 may be NMOS transistors. As another example, the compensation transistor T3 and the first initialization transistor T4 from among the plurality of transistors T1, T2, T3, T4, T5, T6, T7, and T8 may be PMOS transistors, and the other remaining transistors may be NMOS transistors. As another example, the plurality of transistors T1, T2, T3, T4, T5, T6, T7, and T8 may all be NMOS transistors, or may all be PMOS transistors. Hereinafter, an embodiment in which the compensation transistor T3 and the first initialization transistor T4 are NMOS transistors including an oxide semiconductor, and the other remaining transistors are PMOS transistors may be mainly described in more detail as a representative example.

At least one of the plurality of transistors T1, T2, T3, T4, T5, T6, T7, and T8 may be a transistor having a low-temperature polycrystalline silicon (LTPS) semiconductor layer, and at least one other one of the plurality of transistors T1, T2, T3, T4, T5, T6, T7, and T8 may be a transistor having an oxide semiconductor layer.

The driving transistor T1, which may directly affect the brightness of the display device, may include a semiconductor layer including (e.g., composed of) polycrystalline silicon having a high reliability, thereby implementing a high-resolution display device. Further, because an oxide semiconductor may have high carrier mobility and low leakage current, a voltage drop may not be significant even when the display device is driven for a long time. In other words, even during low-frequency driving, a color and/or luminance change of an image due to a voltage drop may not be significant, and thus, the display device may be driven at low frequencies. As described above, because the oxide semiconductor may have a low leakage current, at least one of the compensation transistor T3 and the first initialization transistor T4 connected to a gate electrode (hereinafter, also referred to as "a driving gate electrode") of the driving transistor T1 may have an oxide semiconductor, thereby reducing a power consumption and at the same time, preventing or substantially preventing a leakage current that may flow to the driving gate electrode. For example, the driving transistor T1, the data write transistor T2, the operation control transistor T5, the emission control transistor T6, the second initialization transistor T7, and the bias transistor T8 may be transistors having an LTPS semiconductor layer, and the compensation transistor T3 and the first initialization transistor T4 may be transistors having an oxide semiconductor layer.

The driving transistor T1 may be connected between a driving voltage line (e.g., a vertical driving voltage line) PL and the light-emitting diode LED. The driving voltage line PL may provide the driving voltage ELVDD. A gate electrode of the driving transistor T1 may be connected to one end of the first capacitor Cst, which is a storage capacitor. The gate electrode of the driving transistor T1 may be connected to a first node N1. A source electrode of the driving transistor T1 may be connected to the driving voltage line PL via the operation control transistor T5. A drain electrode of the driving transistor T1 may be electrically connected to a pixel electrode (e.g., an anode) of the light-emitting diode LED via the emission control transistor T6. According to a switching operation of the data write transistor T2, the driving transistor T1 may receive the data signal Dm transferred via the data line DL, and may supply a driving current to the light-emitting diode LED.

A gate electrode (hereinafter, also referred to as "data write gate electrode") of the data write transistor T2 may be connected to the scan line GWL. A first electrode of the data write transistor T2 may be connected to the data line DL, and a second electrode of the data write transistor T2 may be connected to the source electrode of the driving transistor T1. The data write transistor T2 may be turned on according to the scan signal GW received via the scan line GWL, and may transfer the data signal Dm received via the data line DL to the source electrode of the driving transistor T1. The data signal Dm may be transferred to the gate electrode of the driving transistor T1 by the compensation transistor T3.

A gate electrode (hereinafter, also referred to as "compensation gate electrode") of the compensation transistor T3 may be connected to the compensation scan line GCL. A first electrode of the compensation transistor T3 may be connected to the drain electrode of the driving transistor T1, and a second electrode of the compensation transistor T3 may be connected to the first node N1. The compensation transistor T3 may be turned on according to the compensation scan signal GC received via the compensation scan line GCL, and may connect the gate electrode of the driving transistor T1 and the drain electrode of the driving transistor T1 to each other to diode-connect the driving transistor T1, thereby compensating for a threshold voltage (Vth) of the driving transistor T1.

A gate electrode (hereinafter, also referred to as "first initialization gate electrode") of the first initialization transistor T4 may be connected to the first initialization control line GIL. A first electrode of the first initialization transistor T4 may be connected to a first initialization voltage line VIL, and a second electrode of the first initialization transistor T4 may be connected to the first node N1. The first initialization transistor T4 may be turned on according to the first initialization control signal GI applied from the first initialization control line GIL, and may transfer the first initialization voltage Vint to the gate electrode of the driving transistor T1, thereby initializing a voltage of the gate electrode of the driving transistor T1 (e.g., the voltage of the first node N1) to a suitable voltage (e.g., a certain or predetermined voltage). The first initialization voltage Vint may have a higher voltage level than that of the common voltage ELVSS, or may have the same or substantially the same voltage level as that of the common voltage ELVSS.

A gate electrode (hereinafter, also referred to as "an operation control gate electrode") of the operation control transistor T5 may be connected to the emission control line EML. A first electrode of the operation control transistor T5 may be connected to the driving voltage line PL, and a second electrode of the operation control transistor T5 may be connected to the source electrode of the driving transistor T1.

A gate electrode (hereinafter, also referred to as "an emission control gate electrode") of the emission control transistor T6 may be connected to the emission control line EML. A first electrode of the emission control transistor T6 may be connected to the drain electrode of the driving transistor T1, and a second electrode of the emission control transistor T6 may be electrically connected to the pixel electrode of the light-emitting diode LED. The operation control transistor T5 and the emission control transistor T6 may be concurrently (e.g., simultaneously or substantially simultaneously) turned on with each other according to the emission control signal EM applied from the emission control line EML. The driving voltage ELVDD applied via the turned-on operation control transistor T5 may be compensated for through the driving transistor T1, and may be transferred to the light-emitting diode LED.

A gate electrode (hereinafter, also referred to as "a second initialization gate electrode") of the second initialization transistor T7 may be connected to the second initialization control line GBL. A first electrode of the second initialization transistor T7 may be connected to the pixel electrode of the light-emitting diode LED, and a second electrode of the second initialization transistor T7 may be connected to the second initialization voltage line VAL. The second initialization transistor T7 may be turned on according to the second initialization control signal GB applied from the second initialization control line GBL, and may initialize a voltage of the pixel electrode of the light-emitting diode LED. The second initialization control signal GB may be the same signal as the first initialization control signal GI, or may be a signal different from the first initialization control signal GI.

In a comparative example, even when a minimum current of the driving transistor T1 that is configured to display a black image flows as a driving current, in a case where the light-emitting diode LED emits light, the black image may not be displayed properly. However, according to one or more embodiments of the present disclosure, the second initialization transistor T7 may distribute a portion of the minimum current of the driving transistor T1 as a bypass current to other current paths other than a current path toward the light-emitting diode LED. The minimum current of the driving transistor T1 may refer to a current under a condition in which a gate-source voltage (Vgs) of the driving transistor T1 is less than a threshold voltage (Vth), so that the driving transistor T1 is turned off. A minimum driving current (e.g., a current of 10 picoampere (pA) or less) under this condition of turning off the driving transistor T1 may be transferred to the light-emitting diode LED, so that a black luminance image may be represented. When the minimum driving current for displaying a black image flows, a bypass transfer of the bypass current may have a significant influence, whereas when a large driving current for displaying an image flows, such as a normal image or a white image, the bypass current may have little effect. Accordingly, when a driving current for displaying a black image flows, an accurate black luminance image may be implemented from the driving current by using the second initialization transistor T7, thereby improving a contrast ratio. Thus, a display device having improved display quality may be provided.

A gate electrode (hereinafter, also referred to as "a bias gate electrode") of the bias transistor T8 may be connected to the second initialization control line GBL. A first electrode of the bias transistor T8 may be connected to a bias voltage line VOL to which the bias voltage Vobs is provided, and a second electrode of the bias transistor T8 may be connected to the source electrode of the driving transistor T1.

One end of the first capacitor Cst may be connected to the gate electrode of the driving transistor T1, and another end of the first capacitor Cst may be connected to the driving voltage line PL. The first capacitor Cst may be connected between the driving voltage line PL and the first node N1. A voltage corresponding to a voltage difference between the driving voltage ELVDD and a voltage of the first node N1 may be stored in the first capacitor Cst.

The second capacitor Ca may be an auxiliary capacitor, and may be electrically connected to the emission control transistor T6, the second initialization transistor T7, and the first electrode of the light-emitting diode LED. The second capacitor Ca may store and maintain or substantially maintain a voltage corresponding to a voltage difference between the first electrode of the light-emitting diode LED and the common voltage line VSL, while the second initialization transistor T7 is turned on, thereby preventing or substantially preventing an increase in a black luminance when the light-emitting diode LED is turned off.

The pixel electrode of the light-emitting diode LED may receive a driving current from the driving transistor T1 to emit light, and may display an image. The driving voltage ELVDD may be a high-level voltage (e.g., a certain or predetermined high-level voltage), and the common voltage ELVSS may be a voltage lower than the driving voltage ELVDD.

Hereinafter, operation processes of the pixel circuit PC and the light-emitting diode LED will be described in more detail.

During an initialization period, the high-level first initialization control signal GI may be supplied to the first initialization transistor T4 through the first initialization control line GIL, and the low-level second initialization control signal GB may be supplied to the second initialization transistor T7 through the second initialization control line GBL. As a result, the first initialization transistor T4 and the second initialization transistor T7 may each be turned on. The first initialization voltage Vint applied from the first initialization voltage line VIL may be transferred to the gate electrode of the driving transistor T1 through the first initialization transistor T4, and the second initialization voltage Vaint applied from the second initialization voltage line VAL may be transferred to the anode of the light-emitting diode LED through the second initialization transistor T7. Accordingly, voltages of the gate electrode of the driving transistor T1 and the anode of the light-emitting diode LED may be initialized.

Thereafter, during a data write period, the low-level scan signal GW may be supplied through the scan line GWL, and the high-level compensation scan signal GC may be supplied through the compensation scan line GCL. Accordingly, the data write transistor T2 and the compensation transistor T3 may be turned on. The data write transistor T2 may transfer the data signal Dm from the data line DL to the source electrode of the driving transistor T1, and the driving transistor T1 may be diode-connected by the compensation transistor T3. Then, a compensation voltage obtained by subtracting the data signal Dm by a threshold voltage of the driving transistor T1 may be applied to the gate electrode of the driving transistor T1.

The driving voltage ELVDD and the compensation voltage may be applied to opposite ends of a storage capacitor Cst, respectively, and a voltage corresponding to a voltage difference between the opposite ends may be stored in the storage capacitor Cst.

Thereafter, during an emission period, the emission control signal EM supplied from the emission control line EML may be changed from a high level to a low level, and the operation control transistor T5 and the emission control transistor T6 may be turned on. A driving current according to the voltage difference between the voltage at the gate electrode of the driving transistor T1 and the driving voltage ELVDD may be generated, and the driving current may be supplied to the light-emitting diode LED through the emission control transistor T6 to emit light.

Characteristics of the light-emitting diode LED for emitting different kinds of light (e.g., different colored light), and/or characteristics of the driving transistor T1 of each of the pixel circuits PC may be different. In more detail, when the display device is driven at high frequencies, color coordinates of the display device may change (e.g., may become reddish). However, according to one or more embodiments, the voltage at the source electrode of the driving transistor T1 may be controlled through the bias voltage Vobs and the bias transistor T8. As such, the driving current may be controlled, thereby improving a luminance deviation or variation (e.g., a current deviation or variation), and improving a change in color coordinates for each pixel. Thus, a display device having improved display quality may be provided.

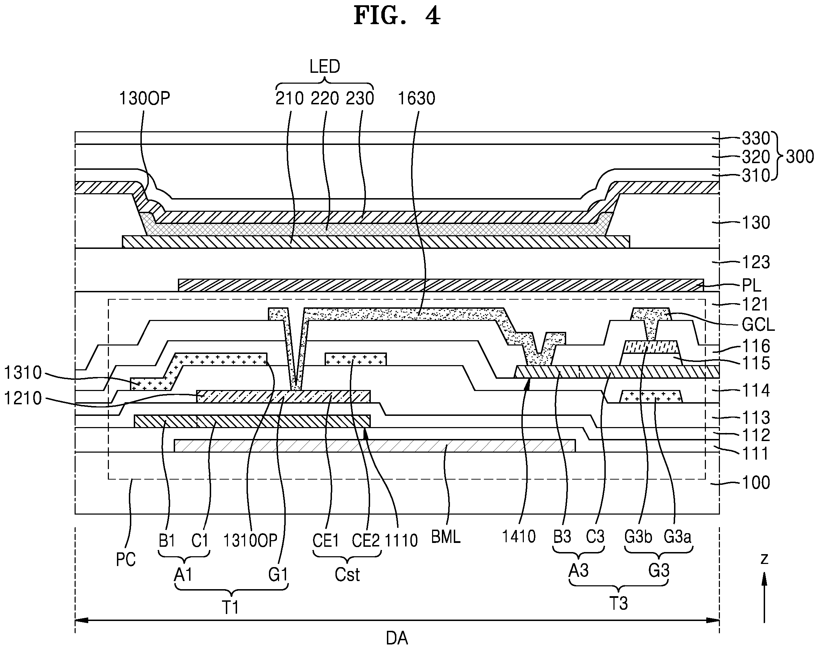

FIG. 4 is a cross-sectional view illustrating a part of the display area DA of a display device according to an embodiment.

Referring to FIG. 4, the pixel circuit PC may be disposed on a substrate 100, and the light-emitting diode LED may be disposed on the pixel circuit PC.

The substrate 100 may include a glass material, a ceramic material, a metal material, a plastic, or other suitable material having flexible or bendable properties. When the substrate 100 has the flexible or bendable properties, the substrate 100 may include a polymer resin, such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate, and/or cellulose acetate propionate (CAP).

The substrate 100 may have a single-layer structure or a multi-layered structure of one or more of the materials described above. In the case of the multi-layered structure, the substrate 100 may further include an inorganic layer. For example, the substrate 100 may include a first organic base layer, a first inorganic barrier layer, a second organic base layer, and a second inorganic barrier layer. The first organic base layer and the second organic base layer may each include a polymer resin. The first inorganic barrier layer and the second inorganic barrier layer may prevent or substantially prevent the permeation of external foreign substances, and may each be a single layer or a plurality of layers including an inorganic insulating material, such as silicon nitride and/or silicon oxide.

A bottom metal layer BML may be disposed on the substrate 100. The bottom metal layer BML may include one or more materials selected from among aluminum (Al), platinum (Pt), palladium (Pd), silver (Ag), magnesium (Mg), gold (Au), nickel (Ni), neodymium (Nd), iridium (Ir), chrome (Cr), lithium (Li), calcium (Ca), molybdenum (Mo), titanium (Ti), tungsten (W), and copper (Cu). In some embodiments, the bottom metal layer BML may be a single layer including Mo, or may have a double-layered structure in which a Mo layer and a Ti layer are stacked. In some embodiments, the bottom metal layer BML may have a triple-layered structure in which a Ti layer, an Al layer, and another Ti layer are stacked.

The bottom metal layer BML may have a voltage level of a constant or substantially constant voltage. For example, the bottom metal layer BML may be electrically connected to the driving voltage line PL described above with reference to FIG. 3, and may have the same voltage level (e.g., the driving voltage ELVDD) as that of the driving voltage line PL. The bottom metal layer BML may prevent or substantially prevent negative (-) charges from gathering under a semiconductor layer (hereinafter, referred to as a "first semiconductor layer" or a "driving semiconductor layer") A1 of the driving transistor T1, thereby preventing, minimizing, or reducing afterimages that may be caused by the negative (-) charges. When viewed in a direction (e.g., ±z direction) perpendicular to an upper surface of the substrate 100 (e.g., in a plan view), the bottom metal layer BML may entirely or substantially entirely overlap with a channel region C1 of the driving semiconductor layer A1 of the driving transistor T1.

A buffer layer 111 may be disposed on the bottom metal layer BML. The buffer layer 111 may be an inorganic insulating layer including an inorganic insulating material, such as silicon nitride and/or silicon oxide, and may have a single-layer structure or a multi-layered structure including one or more of the materials described above.

The transistors including a silicon semiconductor layer may be disposed on the buffer layer 111. For example, FIG. 4 shows the driving semiconductor layer A1 of the driving transistor T1 corresponding to a portion of a first silicon semiconductor pattern 1110. The driving semiconductor layer A1 may include the channel region C1, and doped regions (e.g., source and drain regions) arranged at opposite sides of the channel region C1 and doped with impurities. For example, FIG. 4 shows a first region B1, which is one of the doped regions arranged on one side of the channel region C1.

A first gate insulating layer 112 may be disposed on the first silicon semiconductor pattern 1110, for example, such as on the driving semiconductor layer A1. The first gate insulating layer 112 may be an inorganic insulating layer including an inorganic insulating material, such as silicon oxide, silicon nitride, and/or silicon oxynitride, and may have a single-layer structure or a multi-layered structure including one or more of the materials described above.

A first conductive pattern 1210 may be disposed on the first gate insulating layer 112. The first conductive pattern 1210 may include a driving gate electrode G1, and/or a lower electrode CE1 of the first capacitor Cst. In the first conductive pattern 1210, the driving gate electrode G1 may perform a function of the lower electrode CE1, and/or the lower electrode CE1 may perform a function of the driving gate electrode G1. In other words, the driving gate electrode G1 may be integrally formed as a single body with the lower electrode CE1.

The first conductive pattern 1210, for example, such as the driving gate electrode G1 and/or the lower electrode CE1 of the first capacitor Cst, may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above. In some embodiments, the driving gate electrode G1 and/or the lower electrode CE1 of the first capacitor Cst may include a single layer including Mo.

A second gate insulating layer 113 may be disposed on the driving gate electrode G1 and/or the lower electrode CE1 of the first capacitor Cst. The second gate insulating layer 113 may be an inorganic insulating layer including an inorganic insulating material, such as silicon oxide, silicon nitride, and/or silicon oxynitride, and may have a single-layer structure or a multi-layered structure including one or more of the materials described above.

Another conductive pattern (hereinafter, referred to as "third conductive pattern") 1310 may be disposed on the second gate insulating layer 113. The third conductive pattern 1310 may include an upper electrode CE2 of the first capacitor Cst. The third conductive pattern 1310, for example, such as the upper electrode CE2 of the first capacitor Cst, may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above. In some embodiments, the upper electrode CE2 may include the same material as that of the lower electrode CE1 and/or as that of the bottom metal layer BML.

The upper electrode CE2 may overlap with the driving gate electrode G1 and/or the lower electrode CE1. The upper electrode CE2 may include an opening 1310OP to enable a first connection electrode 1630 to be connected to the driving gate electrode G1. The first connection electrode 1630 may ensure an electrical connection between the driving gate electrode G1 of the driving transistor T1 and a compensation semiconductor layer A3 of the compensation transistor T3. The opening 1310OP may overlap with a part of the driving gate electrode G1.

A first interlayer insulating layer 114 may be disposed on the upper electrode CE2. The first interlayer insulating layer 114 may be an inorganic insulating layer including an inorganic insulating material, such as silicon oxide, silicon nitride, and/or silicon oxynitride, and may have a single-layer structure or a multi-layered structure including one or more of the materials described above.

An oxide semiconductor pattern 1410 may be disposed on the first interlayer insulating layer 114. For example, FIG. 4 shows the compensation semiconductor layer A3 of the compensation transistor T3 corresponding to a portion of the oxide semiconductor pattern 1410. The oxide semiconductor pattern 1410 may include InSnZnO (ITZO), InGaZnO (IGZO), or the like.

The compensation semiconductor layer A3 may include a channel region C3, and conductive regions (e.g., source and drain regions) arranged at opposite sides of the channel region C3. For example, FIG. 4 shows one region B3 of the conductive regions arranged on one side of the channel region C3. The compensation semiconductor layer A3 and the driving semiconductor layer A1 may be disposed at (e.g., in or on) different layers from each other. For example, the driving semiconductor layer A1 may be disposed on the buffer layer 111, and the compensation semiconductor layer A3 may be disposed on the first interlayer insulating layer 114. In other words, a vertical distance from the substrate 100 to the compensation semiconductor layer A3 may be greater than a vertical distance from the substrate 100 to the driving semiconductor layer A1.

A third gate electrode G3 may be disposed under and/or over the compensation semiconductor layer A3. In an embodiment, FIG. 4 shows that the third gate electrode G3 includes a lower compensation gate electrode G3a disposed under the compensation semiconductor layer A3, and an upper compensation gate electrode G3b disposed over the compensation semiconductor layer A3. In another embodiment, either one of the lower compensation gate electrode G3a or the upper compensation gate electrode G3b may be omitted as needed or desired.

The lower compensation gate electrode G3a and the upper electrode CE2 and may include the same material as each other, may be located at (e.g., in or on) the same layer as each other (e.g., on the second gate insulating layer 113). The upper compensation gate electrode G3b may be disposed over the compensation semiconductor layer A3, with a third gate insulating layer 115 therebetween. The upper compensation gate electrode G3b may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above.

FIG. 4 shows that the third gate insulating layer 115 is arranged between (e.g., only between) the upper compensation gate electrode G3b and the compensation semiconductor layer A3. However, the present disclosure is not limited thereto. In another embodiment, the third gate insulating layer 115 may be formed to cover the substrate 100 entirely, similar to another insulating layer, such as the first gate insulating layer 112. The third gate insulating layer 115 may be an inorganic insulating layer including an inorganic insulating material, such as silicon oxide, silicon nitride, and/or silicon oxynitride, and may have a single-layer structure or a multi-layered structure including one or more of the materials described above.

A second interlayer insulating layer 116 may be disposed on the upper compensation gate electrode G3b. The second interlayer insulating layer 116 may be an inorganic insulating layer including an inorganic insulating material, such as silicon oxide, silicon nitride, and/or silicon oxynitride, and may have a single-layer structure or a multi-layered structure including one or more of the materials described above.

The first connection electrode 1630 and the compensation scan line GCL may be disposed on the second interlayer insulating layer 116. The first connection electrode 1630 and the compensation scan line GCL may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above. In an embodiment, the first connection electrode 1630 and the compensation scan line GCL may have a three-layered structure of an Al layer/Ti layer/Al layer. The compensation scan line GCL may be electrically connected to the upper compensation gate electrode G3b through a contact hole passing through (e.g., penetrating) the second interlayer insulating layer 116.

A first organic insulating layer 121 may be formed on the first connection electrode 1630 and the compensation scan line GCL. The first organic insulating layer 121 may include an organic material, such as acryl, benzocyclobutene (BCB), PI, or hexamethyldisiloxane (HMDSO).

The driving voltage line PL may be disposed on the first organic insulating layer 121. The driving voltage line PL may overlap with the driving transistor T1 and the first capacitor Cst. In some embodiments, the driving voltage line PL may overlap with the compensation transistor T3. In some embodiments, the driving voltage line PL may overlap with the first initialization transistor T4. The driving voltage line PL may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above. In an embodiment, the driving voltage line PL may have a three-layered structure of an Al layer/Ti layer/Al layer.

A second organic insulating layer 123 may be disposed on the driving voltage line PL. The second organic insulating layer 123 may include an organic material, such as BCB, PI, or HMDSO.

The light-emitting diode LED may be formed on the second organic insulating layer 123. The light-emitting diode LED may include a pixel electrode 210, an intermediate layer 220, and an opposite electrode 230, which are disposed (e.g., sequentially disposed) on the second organic insulating layer 123.

An edge of the pixel electrode 210 may be covered by a bank layer 130. An inner portion of the pixel electrode 210 may overlap with the intermediate layer 220 through an opening 130OP defined in the bank layer 130. While the pixel electrode 210 is formed for each light-emitting diode LED, the opposite electrode 230 may be formed to correspond to a plurality of light-emitting diodes LED. In other words, the plurality of light-emitting diodes LED may share the opposite electrode 230 with each other, and a stacked structure of the pixel electrode 210, the intermediate layer 220, and the opposite electrode 230 may correspond to the light-emitting diode LED.

The intermediate layer 220 may include an emission layer. In some embodiments, the intermediate layer 220 may include an emission layer, and may further include a functional layer. The functional layer may include a hole transport layer (HTL), a hole injection layer (HIL), an electron transport layer (ETL), and/or an electron injection layer (EIL). In some embodiments, the intermediate layer 220 may include a first stack including an emission layer and a functional layer, a second stack including an emission layer and a functional layer, and a charge generation layer between the first stack and the second stack. The charge generation layer may include a negative charge generation layer and a positive charge generation layer. Because of the negative charge generation layer and the positive charge generation layer, an emission efficiency of a tandem light-emitting diode LED having a plurality of emission layers may be further increased.

The negative charge generation layer may be an N-type charge generation layer. The negative charge generation layer may supply electrons. The negative charge generation layer may include a host and a dopant. The host may include an organic material. The dopant may include a metal material. The positive charge generation layer may be a P-type charge generation layer. The positive charge generation layer may supply holes. The positive charge generation layer may include a host and a dopant. The host may include an organic material. The dopant may include a metal material.

An encapsulation layer 300 may be disposed on the light-emitting diode LED. The encapsulation layer 300 may include at least one inorganic encapsulation layer and at least one organic encapsulation layer. FIG. 4 illustrates an embodiment in which the encapsulation layer 300 includes a first inorganic encapsulation layer 310, an organic encapsulation layer 320, and a second inorganic encapsulation layer 330. The first inorganic encapsulation layer 310 and the second inorganic encapsulation layer 330 may include silicon oxide, silicon nitride, and/or silicon oxynitride. The organic encapsulation layer 320 may include an organic insulating material.

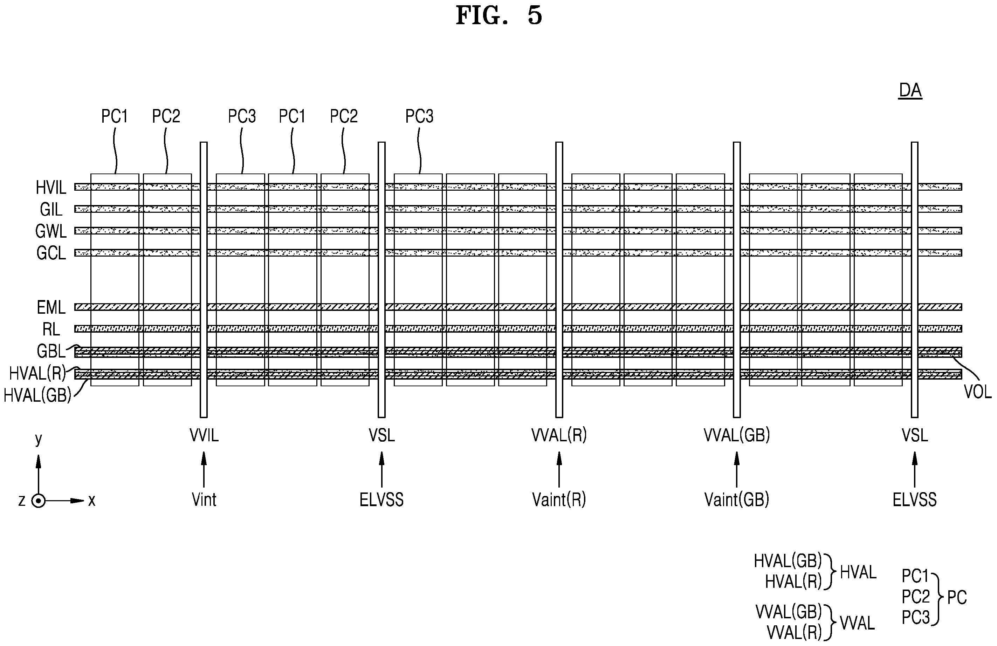

FIG. 5 is a plan view schematically illustrating some lines arranged in the display area DA of a display device, according to an embodiment. The pixel circuits PC may be arranged along a first direction (e.g., the ±x direction) and a second direction (e.g., the ±y direction). FIG. 5 shows the pixel circuits PC arranged in the same row as each other (e.g., in an i^{th} row, where i is a natural number greater than zero).

The pixel circuits PC may be electrically connected to light-emitting diodes, respectively. Hereinafter, for convenience of illustration, the pixel circuits PC that are electrically connected to first to third light-emitting diodes, respectively, for emitting light of different colors from each other may be referred to as first to third pixel circuits PC1, PC2, and PC3.

The first pixel circuit PC1 may be electrically connected to a first light-emitting diode for emitting light of a first color. The second pixel circuit PC2 may be electrically connected to a second light-emitting diode for emitting light of a second color. The third pixel circuit PC3 may be electrically connected to a third light-emitting diode for emitting light of a third color. In some embodiments, the first color, the second color, and the third color may be different colors from each other, and may be selected from among red, green, and blue.

The first to third pixel circuits PC1, PC2, and PC3 may be repeatedly arranged along the first direction (e.g., the ±x direction). The first to third pixel circuits PC1 to PC3 may be arranged in an order of the first pixel circuit PC1, the second pixel circuit PC2, and the third pixel circuit PC3 along the first direction (e.g., the ±x direction). A spaced distance between the second pixel circuit PC2 and the third pixel circuit PC3 may be greater than a spaced distance between the second pixel circuit PC2 and the first pixel circuit PC1.

In the display area DA, lines electrically connected to the pixel circuits PC, for example, such as first conductive lines (hereinafter, referred to as "horizontal conductive lines") extending in the first direction (e.g., the ±x direction) and second conductive lines (hereinafter, referred to as "vertical conductive lines") extending in the second direction (e.g., the ±y direction), may be arranged.

The horizontal conductive lines extending in the first direction (e.g., the ±x direction) may include a first initialization horizontal voltage line HVIL, the first initialization control line GIL, the scan line GWL, the compensation scan line GCL, the emission control line EML, a repair line RL, the second initialization control line GBL, the bias voltage line VOL, and/or a second initialization horizontal voltage line HVAL. The second initialization horizontal voltage line HVAL may include a second-first initialization horizontal voltage line HVAL(R) (also referred to as "a first horizontal voltage line") and a second-second initialization horizontal voltage line HVAL(GB) (also referred to as "a second horizontal voltage line").

The vertical conductive lines extending in the second direction (e.g., the ±y direction) may include a first initialization vertical voltage line VVIL, the common voltage line VSL to provide the common voltage ELVSS, and a second initialization vertical voltage line VVAL. The second initialization vertical voltage line VVAL may include a second-first initialization vertical voltage line VVAL(R) and a second-second initialization vertical voltage line VVAL(GB).

The first initialization vertical voltage line VVIL and the first initialization horizontal voltage line HVIL, which provide the first initialization voltage Vint, may be electrically connected to each other in the display area DA. The second-first initialization horizontal voltage line HVAL(R) and the second-first initialization vertical voltage line VVAL(R), which provide a second-first initialization voltage Vaint(R) to the first pixel circuit PC1, may be electrically connected to each other in the display area DA. The second-second initialization vertical voltage line VVAL(GB) and the second-second initialization horizontal voltage line HVAL(GB), which provide a second-second initialization voltage Vaint (GB) to the second pixel circuit PC2 and the third pixel circuit PC3, may be electrically connected to each other in the display area DA.

In FIG. 5, the second pixel circuit PC2 and the third pixel circuit PC3 are electrically connected to the same voltage line (e.g., to the second-second initialization vertical voltage line VVAL(GB) and/or the second-second initialization horizontal voltage line HVAL(GB)). However, the present disclosure is not limited thereto. In another embodiment, horizontal and vertical voltage lines for applying the second initialization voltage to the second pixel circuit PC2, and horizontal and vertical voltage lines for applying the second initialization voltage to the third pixel circuit PC3 may be present independently of each other.

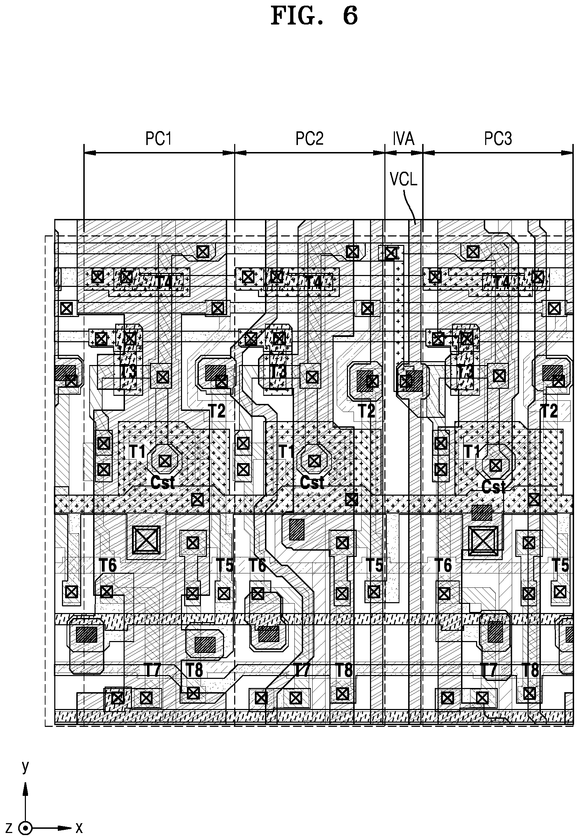

FIG. 6 is a plan view of first to third pixel circuits PC1 to PC3 of a display device, according to an embodiment. The first pixel circuit PC1, the second pixel circuit PC2, and the third pixel circuit PC3 shown in FIG. 6 may be arranged along the i^{th} row.

Referring to FIG. 6, each of the first pixel circuit PC1, the second pixel circuit PC2, and the third pixel circuit PC3 may include a plurality of transistors and a capacitor. In some embodiments, FIG. 6 illustrates that each of the first pixel circuit PC1, the second pixel circuit PC2, and the third pixel circuit PC3 includes eight transistors T1, T2, T3, T4, T5, T6, T7, and T8 and the first capacitor Cst. For example, but not restricted thereto, the eight transistors T1, T2, T3, T4, T5, T6, T7, and T8 and the first capacitor Cst may refer to the pixel circuit described above with reference to FIG. 3. However, the pixel circuits are not restricted to the pixel circuits as disclosed in the example embodiment of FIG. 3.

The driving transistor T1 may overlap with the first capacitor Cst. In a plan view, the switching transistors (e.g., T2, T3, T4, T5, T6, T7, and T8) may be disposed over and/or under the driving transistor T1 and/or the first capacitor Cst. In an embodiment, FIG. 6 illustrates that, in a plan view, the data write transistor T2, the compensation transistor T3, and the first initialization transistor T4 are disposed over or above (e.g., in the +y direction) the driving transistor T1 and/or the first capacitor Cst. In a plan view, the operation control transistor T5, the emission control transistor T6, the second initialization transistor T7, and the bias transistor T8 may be disposed under or below (e.g., in the -y direction) the driving transistor T1 and/or the first capacitor Cst.

The first pixel circuit PC1, the second pixel circuit PC2, and the third pixel circuit PC3 may be arranged along the first direction (e.g., the ±x direction). A first spaced distance between the second pixel circuit PC2 and the third pixel circuit PC3 may be greater than a second spaced distance between the first pixel circuit PC1 and the second pixel circuit PC2. A vertical voltage line VCL may be arranged in a space (hereinafter, referred to as "a separation space") IVA between the second pixel circuit PC2 and the third pixel circuit PC3 having the first spaced distance therebetween. The vertical voltage line VCL shown in FIG. 6 may be the first initialization vertical voltage line VVIL, the common voltage line VSL, the second-first initialization vertical voltage line VVAL(R), and/or the second-second initialization vertical voltage line VVAL(GB) described above with reference to FIG. 5.

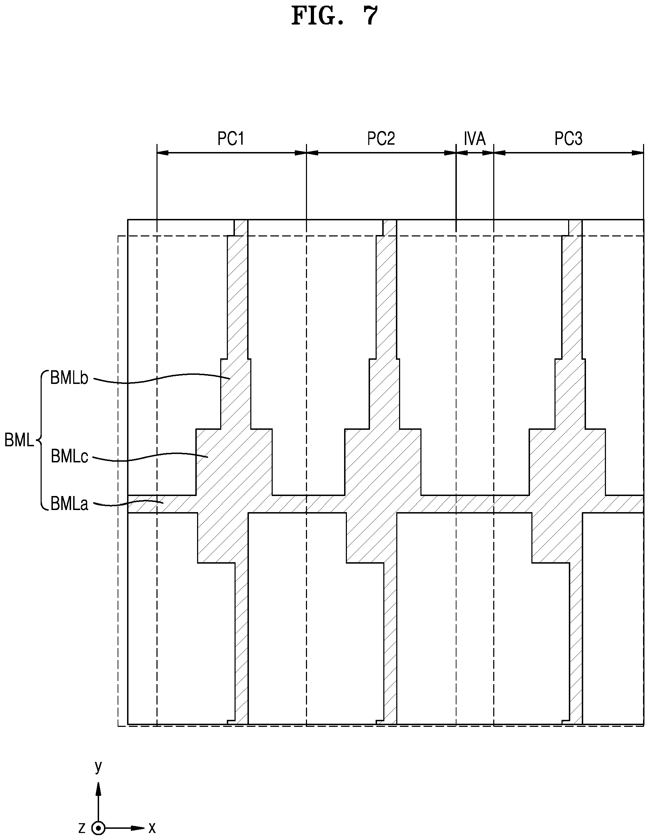

FIGS. 7 through 15 are plan views showing a method of forming the first to third pixel circuits PC1 to PC3 shown in FIG. 6 and, in addition, illustrate the structural features of the first to third pixel circuits PC1 to PC3.

Referring to FIG. 7, the bottom metal layer BML may be disposed on the substrate 100 (e.g., see FIG. 4). The bottom metal layer BML may include a main portion BMLc for (e.g., corresponding to) each of the first to third pixel circuits PC1, PC2, and PC3. The bottom metal layer BML may further include first branch portions BMLa connecting the main portions BMLc to each other along the first direction (e.g., the ±x direction), and second branch portions BMLb connecting, along the second direction (e.g., the ±y direction), the main portions BMLc arranged in each of the pixel circuits disposed at (e.g., in or on) different rows. The main portion BMLc, a first branch portion BMLa of the first branch portions BMLa, and a second branch portion BMLb of the second branch portions BMLb may be integrally connected to each other as a single body.

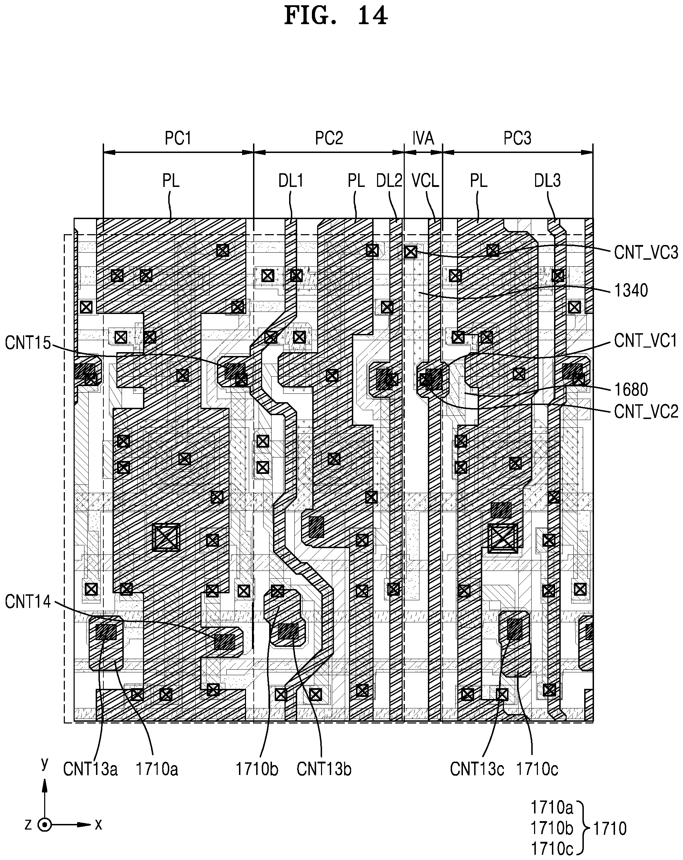

The bottom metal layer BML may be electrically connected to the driving voltage line PL (e.g., see FIG. 3), and may have the same voltage level as that of the driving voltage line PL (e.g., see FIG. 14) described in more detail below.

The bottom metal layer BML may include one or more materials selected from among Al, Pt, Pd, Ag, Mg, Au, Ni, Nd, Ir, Cr, Li, Ca, Mo, Ti, W, and Cu. In some embodiments, the bottom metal layer BML may be a single layer including Mo, may have a double-layered structure in which a Mo layer and a Ti layer are stacked, or may have a triple-layered structure in which a Ti layer, an Al layer, and another Ti layer are stacked.

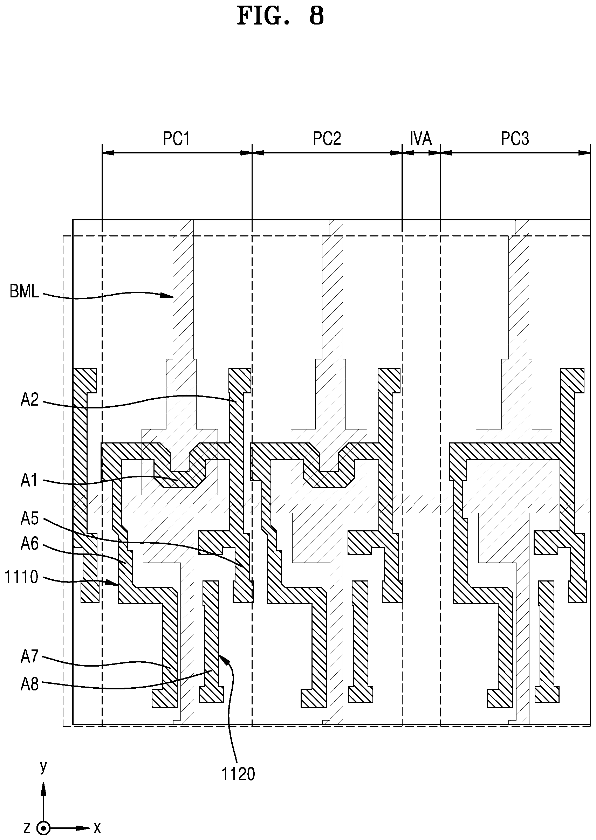

Referring to FIGS. 7 and 8, the buffer layer 111 (e.g., see FIG. 4) may be disposed on the bottom metal layer BML, and the first silicon semiconductor pattern 1110 and a second silicon semiconductor pattern 1120 may be disposed on the buffer layer 111.

The first silicon semiconductor pattern 1110 and the second silicon semiconductor pattern 1120 may be arranged to correspond to each of the first to third pixel circuits PC1, PC2, and PC3. The first silicon semiconductor pattern 1110 arranged in each of the first to third pixel circuits PC1, PC2, and PC3 may be separated and spaced apart from the others. The first silicon semiconductor pattern 1110 and the second silicon semiconductor pattern 1120 corresponding to the same pixel circuit may be spaced apart from each other. However, the present disclosure is not limited thereto. In another embodiment, the first silicon semiconductor pattern 1110 and the second silicon semiconductor pattern 1120 corresponding to the same pixel circuit may be integrally connected to each other as a single body.

The first silicon semiconductor pattern 1110 may include the driving semiconductor layer A1 of the driving transistor T1 described above with reference to FIG. 6, a semiconductor layer (hereinafter, referred to as "data write semiconductor layer") A2 of the data write transistor T2 (e.g., see FIG. 6), a semiconductor layer (hereinafter, referred to as "operation control semiconductor layer") A5 of the operation control transistor T5 (e.g., see FIG. 6), a semiconductor layer (hereinafter, referred to as "emission control semiconductor layer") A6 of the emission control transistor T6 (e.g., see FIG. 6), and a semiconductor layer (hereinafter, referred to as "second initialization semiconductor layer") A7 of the second initialization transistor T7 (e.g., see FIG. 6). The second silicon semiconductor pattern 1120 may include a semiconductor layer (hereinafter, referred to as "a bias semiconductor layer") A8 of the bias transistor T8 (e.g., see FIG. 6).

The first silicon semiconductor pattern 1110 and the second silicon semiconductor pattern 1120 may include amorphous silicon or polysilicon. For example, the first silicon semiconductor pattern 1110 and the second silicon semiconductor pattern 1120 may include polysilicon crystallized at a low temperature.

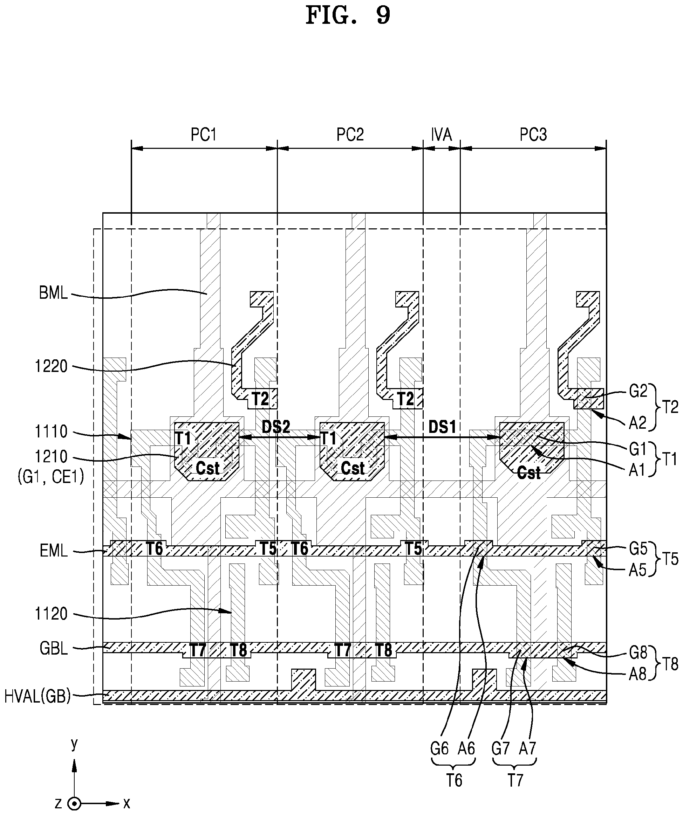

Referring to FIGS. 8 and 9, the first gate insulating layer 112 (e.g., see FIG. 4) may be disposed on the first silicon semiconductor pattern 1110 and the second silicon semiconductor pattern 1120. The first conductive pattern 1210, a second conductive pattern 1220, the emission control line EML, the second initialization control line GBL, and the second-second initialization horizontal voltage line HVAL(GB) may be disposed on the first gate insulating layer 112 (e.g., see FIG. 4).

The first conductive pattern 1210, the second conductive pattern 1220, the emission control line EML, the second initialization control line GBL, and the second-second initialization horizontal voltage line HVAL(GB) may include the same material as each other. The first conductive pattern 1210, the second conductive pattern 1220, the emission control line EML, the second initialization control line GBL, and the second-second initialization horizontal voltage line HVAL(GB) may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above.

Each of the first conductive pattern 1210, the second conductive pattern 1220, the emission control line EML, and the second initialization control line GBL may include a gate electrode overlapping with the first silicon semiconductor pattern 1110 and/or second semiconductor pattern 1120.

The first conductive pattern 1210 may be arranged in each of the first to third pixel circuits PC1, PC2, and PC3, and may have an isolated shape. The first conductive pattern 1210 may include the driving gate electrode G1 of the driving transistor T1. The driving semiconductor layer A1 may include a channel region overlapping with the first conductive pattern 1210, which is the driving gate electrode G1, and a source region and a drain region arranged at opposite sides of the channel region. Referring to FIGS. 7 and 9, the channel region of the driving semiconductor layer A1 may overlap with a part (e.g., the main portion BMLc) of the bottom metal layer BML. This may prevent or substantially prevent negative (-) charges from gathering thereby preventing, minimizing, or reducing afterimages that may be caused by the negative (-) charges. A shape of the channel region of the driving semiconductor layer A1 of each of the first and second pixel circuits PC1 and PC2 may be a shape that is bent a plurality of times (e.g., an omega shape). Considering the efficiency of the third light-emitting diode electrically connected to the third pixel circuit PC3, a shape of the channel region of the driving semiconductor layer A1 of the third pixel circuit PC3 may be a straight shape.

The spaced distance between the second pixel circuit PC2 and the third pixel circuit PC3 being greater than the spaced distance between the second pixel circuit PC2 and the first pixel circuit PC1 may be understood from the spaced distance between the driving transistor T1 of the second pixel circuit PC2 and the driving transistor T1 of the third pixel circuit PC3 being greater than the spaced distance between the driving transistor T1 of the second pixel circuit PC2 and the driving transistor T1 of the first pixel circuit PC1. For example, a first spaced distance DS1 between the channel region of the driving transistor T1 of the second pixel circuit PC2 and the channel region of the driving transistor T1 of the third pixel circuit PC3, measured in the first direction (e.g., ±x direction), may be greater than a second spaced distance DS2 between the channel region of the driving transistor T1 of the second pixel circuit PC2 and the channel region of the driving transistor T1 of the first pixel circuit PC1, measured in the first direction (e.g., ±x direction). In other words, it may be understood that the first spaced distance DS1 between the driving gate electrode G1 of the driving transistor T1 of the second pixel circuit PC2 and the driving gate electrode G1 of the driving transistor T1 of the third pixel circuit PC3, measured in the first direction (e.g., the ±x direction), is greater than the second spaced distance DS2 between the driving gate electrode G1 of the driving transistor T1 of the second pixel circuit PC2 and the driving gate electrode G1 of the driving transistor T1 of the first pixel circuit PC1, measured in the first direction (e.g., ±x direction).

In some embodiments, the first conductive pattern 1210 may include the lower electrode CE1 of the first capacitor Cst. The first conductive pattern 1210 may be the driving gate electrode G1 and/or the lower electrode CE1 of the first capacitor Cst.

The second conductive pattern 1220 may be arranged in each of the first to third pixel circuits PC1, PC2, and PC3, and may have an isolated shape. The second conductive pattern 1220 may include a data write gate electrode G2 of the data write transistor T2. The data write semiconductor layer A2 may include a channel region overlapping with the data write gate electrode G2 of the data write transistor T2, and a source region and a drain region arranged at opposite sides of the channel region.

The emission control line EML may extend in the first direction (e.g., the ±x direction) to pass through the first to third pixel circuits PC1, PC2, and PC3. The emission control line EML may include an operation control gate electrode G5 of the operation control transistor T5, and an emission control gate electrode G6 of the emission control transistor T6. The operation control semiconductor layer A5 may include a channel region overlapping with the operation control gate electrode G5, and a source region and a drain region arranged at opposite sides of the channel region. The emission control semiconductor layer A6 may include a channel region overlapping with the emission control gate electrode G6, and a source region and a drain region arranged at opposite sides of the channel region.

The second initialization control line GBL may extend in the first direction (e.g., the ±x direction) to pass through the first to third pixel circuits PC1, PC2, and PC3. The second initialization control line GBL may include a second initialization gate electrode G7 of the second initialization transistor T7, and a bias gate electrode G8 of the bias transistor T8. The second initialization semiconductor layer A7 may include a channel region overlapping with the second initialization gate electrode G7, and a source region and a drain region arranged at opposite sides of the channel region. The bias semiconductor layer A8 may include a channel region overlapping with the bias gate electrode G8, and a source region and a drain region arranged at opposite sides of the channel region.

The second gate insulating layer 113 (e.g., see FIG. 4) may be disposed on the first conductive pattern 1210, the second conductive pattern 1220, the emission control line EML, the second initialization control line GBL, and the second-second initialization horizontal voltage line HVAL(GB) described above with reference to FIG. 9.

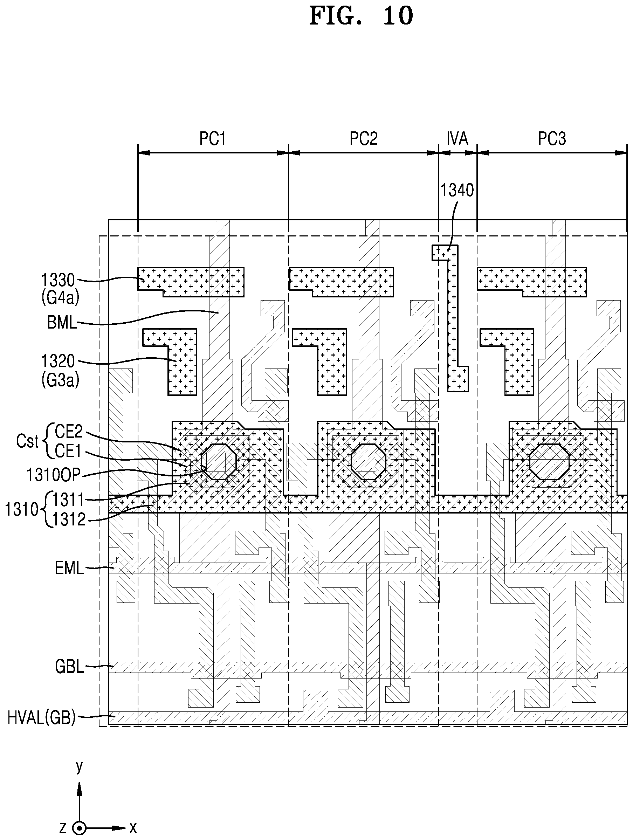

Thereafter, as shown in FIG. 10, the third conductive pattern 1310, a fourth conductive pattern 1320, a fifth conductive pattern 1330, and a bridge pattern 1340 may be disposed on the second gate insulating layer 113 (e.g., see FIG. 4).

The third conductive pattern 1310, the fourth conductive pattern 1320, the fifth conductive pattern 1330, and the bridge pattern 1340 may include the same material as each other. The third conductive pattern 1310, the fourth conductive pattern 1320, the fifth conductive pattern 1330, and the bridge pattern 1340 may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above.

Referring to FIGS. 9 and 10, the third conductive pattern 1310 may be arranged to overlap with the first conductive pattern 1210. The third conductive pattern 1310 may be a horizontal driving voltage line having the voltage level of the driving voltage ELVDD (e.g., see FIG. 3), and may extend in the first direction (e.g., the ±x direction) to pass through the first to third pixel circuits PC1, PC2, and PC3.

In an embodiment, the third conductive pattern 1310 may include first portions 1311 overlapping with the first conductive pattern 1210 (e.g., see FIG. 9) arranged in each of the first to third pixel circuits PC1, PC2, and PC3, and a second portion 1312 extending in the first direction (e.g., the ±x direction) to connect the first portions 1311 arranged in each of the first to third pixel circuits PC1, PC2, and PC3 to each other.

The first conductive pattern 1210 (e.g., see FIG. 9) arranged in each of the first to third pixel circuits PC1, PC2, and PC3 may correspond to the lower electrode CE1 of the first capacitor Cst. The first portion 1311 of the third conductive pattern 1310 arranged in each of the first to third pixel circuits PC1, PC2, and PC3 may correspond to the upper electrode CE2 of the first capacitor Cst.

The third conductive pattern 1310 may overlap with the bottom metal layer BML. Referring to FIGS. 7 and 10, the first portion 1311 of the third conductive pattern 1310 may overlap with the main portion BMLc of the bottom metal layer BML, and the second portion 1312 of the third conductive pattern 1310 may overlap with the first branch portion BMLa of the bottom metal layer BML.

By arranging the third conductive pattern 1310 and the bottom metal layer BML having the same voltage as each other to overlap with each other, a coupling between the driving transistor T1 and the elements therearound (e.g., a wiring or electrodes) may be prevented or substantially prevented. By efficiently arranging the transistors, the voltage lines, and the signal lines of the first to third pixel circuits PC1, PC2, and PC3 in a limited space, a space efficiency may be improved (e.g., an integration degree may be improved). The third conductive pattern 1310 may have the opening 1310OP having a closed shape.

Each of the fourth conductive pattern 1320 and the fifth conductive pattern 1330 may be arranged in each of the first to third pixel circuits PC1, PC2, and PC3. Each of the fourth conductive pattern 1320 and the fifth conductive pattern 1330 may have an isolated shape.

The fourth conductive pattern 1320 may correspond to the lower compensation gate electrode G3a of the compensation transistor T3 described in more detail below, and the fifth conductive pattern 1330 may correspond to a lower first initialization gate electrode G4a of the first initialization transistor T4 described in more detail below.

The bridge pattern 1340 may be arranged in a separation space IVA between the second pixel circuit PC2 and the third pixel circuit PC3.

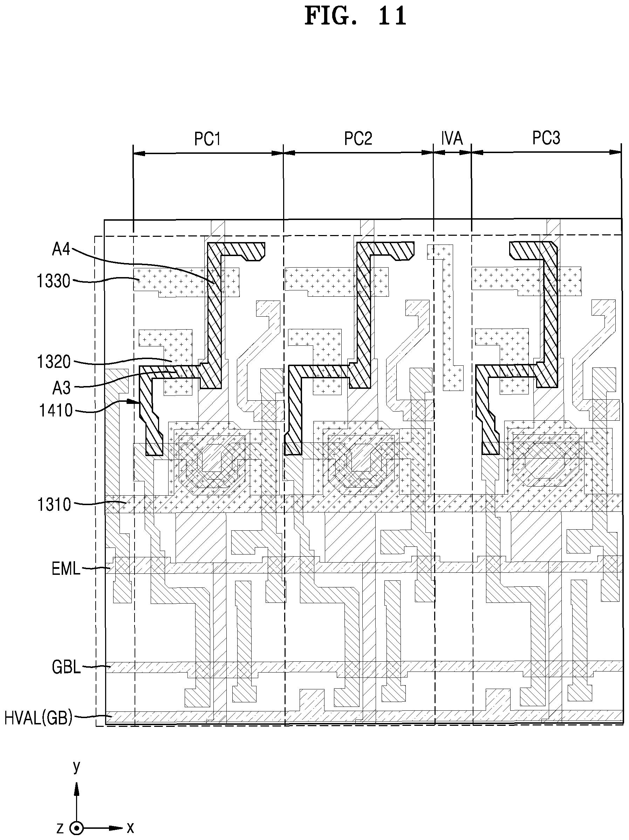

The first interlayer insulating layer 114 (e.g., see FIG. 4) may be disposed on the third conductive pattern 1310, the fourth conductive pattern 1320, the fifth conductive pattern 1330, and the bridge pattern 1340. Thereafter, as shown in FIG. 11, the oxide semiconductor pattern 1410 may be formed on the first interlayer insulating layer 114 (e.g., see FIG. 4).

Referring to FIG. 11, the oxide semiconductor pattern 1410 may have a bent shape. For example, the oxide semiconductor pattern 1410 may include a portion corresponding to the compensation semiconductor layer A3 extending in the first direction (e.g., the ±x direction) to overlap with the fourth conductive pattern 1320, and a portion corresponding to a first initialization semiconductor layer A4 extending in the second direction (e.g., the ±y direction) to overlap with the fifth conductive pattern 1330.

The oxide semiconductor pattern 1410 may be an ITZO semiconductor layer, an IGZO semiconductor layer, or the like. Because the oxide semiconductor may have a large band gap (e.g., about 3.1 eV), a high carrier mobility, and a low leakage current, even when a driving time is long, a voltage drop may not be significant so that a color and/or luminance change of an image due to the voltage drop may not be significant even when the display device is driven at low frequencies.

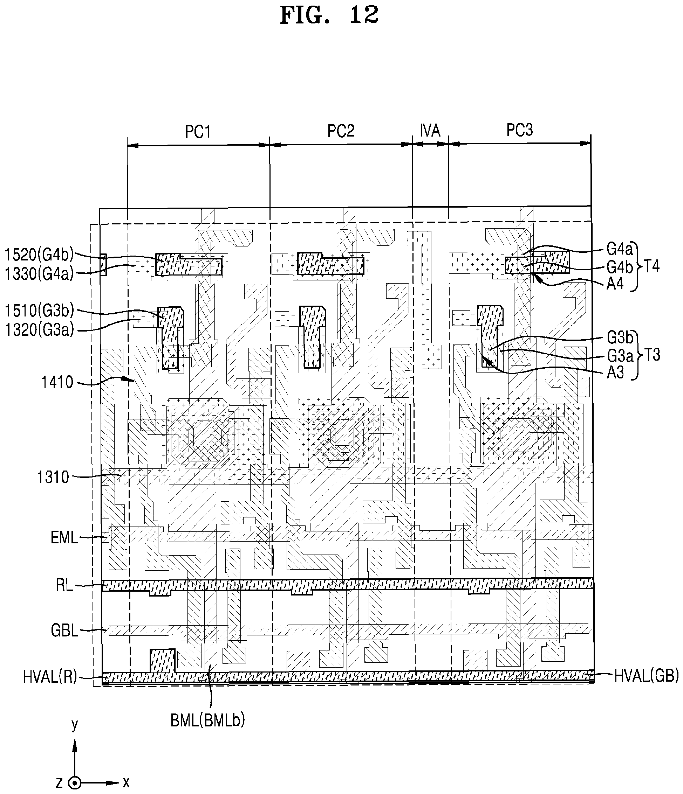

Referring to FIG. 12, a sixth conductive pattern 1510, a seventh conductive pattern 1520, a repair line RL, and the second-first initialization horizontal voltage line HVAL(R) may be disposed on the structure described above with reference to FIG. 11.

The sixth conductive pattern 1510, the seventh conductive pattern 1520, the repair line RL, and the second-first initialization horizontal voltage line HVAL(R) may include the same material as each other. The sixth conductive pattern 1510, the seventh conductive pattern 1520, the repair line RL, and the second-first initialization horizontal voltage line HVAL(R) may include Al, Pt, Pd, Ag, Mg, Au, Ni, Nd, Ir, Cr, Li, Ca, Mo, Ti, W, and/or Cu, and may be formed of a single layer or a plurality of layers including one or more of the materials described above. In an embodiment, the sixth conductive pattern 1510, the seventh conductive pattern 1520, the repair line RL, and the second-first initialization horizontal voltage line HVAL(R) may have a three-layered structure of an Al layer/Ti layer/Al layer.

Each of the sixth conductive pattern 1510 and the seventh conductive pattern 1520 may be arranged in each of the first to third pixel circuits PC1, PC2, and PC3. Each of the sixth conductive pattern 1510 and the seventh conductive pattern 1520 may have an isolated shape.

Each of the sixth conductive pattern 1510 and the seventh conductive pattern 1520 may overlap with the oxide semiconductor pattern 1410, and may include a gate electrode. The sixth conductive pattern 1510 may include a portion (e.g., the upper compensation gate electrode G3b) overlapping with the compensation semiconductor layer A3 of the oxide semiconductor pattern 1410. The seventh conductive pattern 1520 may include a portion (e.g., an upper first initialization gate electrode G4b) overlapping with the first initialization semiconductor layer A4 of the oxide semiconductor pattern 1410.

The compensation semiconductor layer A3 arranged in each of the first to third pixel circuits PC1, PC2, and PC3 may include a channel region overlapping with the fourth conductive pattern 1320 and the sixth conductive pattern 1510, and a source region and a drain region arranged at opposite sides of the channel region. The fourth conductive pattern 1320 may be disposed under the compensation semiconductor layer A3, and the sixth conductive pattern 1510 may be disposed over the compensation semiconductor layer A3. The first initialization semiconductor layer A4 disposed in each of the first to third pixel circuits PC1, PC2, and PC3 may include a channel region overlapping with the fifth conductive pattern 1330 and the seventh conductive pattern 1520, and a source region and a drain region arranged at opposite sides of the channel region. The fifth conductive pattern 1330 may be disposed under the first initialization semiconductor layer A4, and the seventh conductive pattern 1520 may be disposed over the first initialization semiconductor layer A4.

The fourth conductive pattern 1320 and the sixth conductive pattern 1510 may correspond to the lower compensation gate electrode G3a and the upper compensation gate electrode G3b of the compensation transistor T3, respectively. The fifth conductive pattern 1330 and the seventh conductive pattern 1520 may correspond to the lower first initialization gate electrode G4a and the upper first initialization gate electrode G4b of the first initialization transistor T4, respectively.

In FIG. 12, the compensation transistor T3 includes a double-gate electrode of the lower compensation gate electrode G3a and the upper compensation gate electrode G3b, and the first initialization transistor T4 includes a double-gate electrode of the lower first initialization gate electrode G4a and the upper first initialization gate electrode G4b. However, the present disclosure is not limited thereto. In another embodiment, the compensation transistor T3 may include one gate electrode from among the lower compensation gate electrode G3a and/or the upper compensation gate electrode G3b, and the first initialization transistor T4 may include one gate electrode from among the lower first initialization gate electrode G4a and the upper first initialization gate electrode G4b.

The second-first initialization horizontal voltage line HVAL(R) may be arranged at (e.g., in or on) the same layer as that of the sixth conductive pattern 1510, which is the gate electrode (e.g., the upper compensation gate electrode G3b) of the compensation transistor T3, the seventh conductive pattern 1520, which is the gate electrode (e.g., the upper first initialization gate electrode G4b) of the first initialization transistor T4, and the repair line RL. For example, each of the second-first initialization horizontal voltage line HVAL(R), the sixth conductive pattern 1510, the seventh conductive pattern 1520, and the repair line RL may be disposed on the third gate insulating layer 115 (e.g., see FIG. 4).

In some embodiments, as described above with reference to FIG. 4, the third gate insulating layers 115 respectively disposed under the sixth conductive pattern 1510, the seventh conductive pattern 1520, the repair line RL, and the second-first initialization horizontal voltage line HVAL(R) may be spaced apart (e.g., may be separated) from each other. However, the present disclosure is not limited thereto. In another embodiment, the third gate insulating layers 115 (e.g., see FIG. 4) respectively disposed under the sixth conductive pattern 1510, the seventh conductive pattern 1520, the repair line RL, and the second-first initialization horizontal voltage line HVAL(R) may be integrally connected to each other.

The second-first initialization horizontal voltage line HVAL(R) and the second-second initialization horizontal voltage line HVAL(GB) may overlap with each other. The second-second initialization horizontal voltage line HVAL(GB) and the second-first initialization horizontal voltage line HVAL(R) may have a voltage level of constant or substantially constant voltage. For example, the second-second initialization horizontal voltage line HVAL(GB) and the second-first initialization horizontal voltage line HVAL(R) may have the same or similar voltage level as each other. Because the second-second initialization horizontal voltage line HVAL(GB) and the second-first initialization horizontal voltage line HVAL(R) having the same or similar voltage level as each other may be arranged to overlap with each other, a space may be more efficiently used (e.g., a degree of integration may be improved), while minimizing or reducing the occurrence of a parasitic capacitance between electrodes of the transistors, the voltage lines, and/or the signal lines of the first to third pixel circuits PC1, PC2, and PC3 in a limited space.

As shown in FIG. 12, in a plan view, each of the second-first initialization horizontal voltage line HVAL(R) and the second-second initialization horizontal voltage line HVAL(GB) may cross the second branch portion BMLb of the bottom metal layer BML.

In FIG. 12, the second-first initialization horizontal voltage line HVAL(R) is arranged at (e.g., in or on) the same layer and includes the same material as those of the sixth conductive pattern 1510, which is the upper compensation gate electrode G3b of the compensation transistor T3, and/or as those of the seventh conductive pattern 1520, which is the upper first initialization gate electrode G4b of the first initialization transistor T4. However, the present disclosure is not limited thereto. In another embodiment, the second-first initialization horizontal voltage line HVAL(R) may be arranged at (e.g., in or on) the same layer and includes the same material as those of the fourth conductive pattern 1320, which is the lower compensation gate electrode G3a of the compensation transistor T3, and/or as those of the fifth conductive pattern 1330, which is the lower first initialization gate electrode G4a of the first initialization transistor T4.

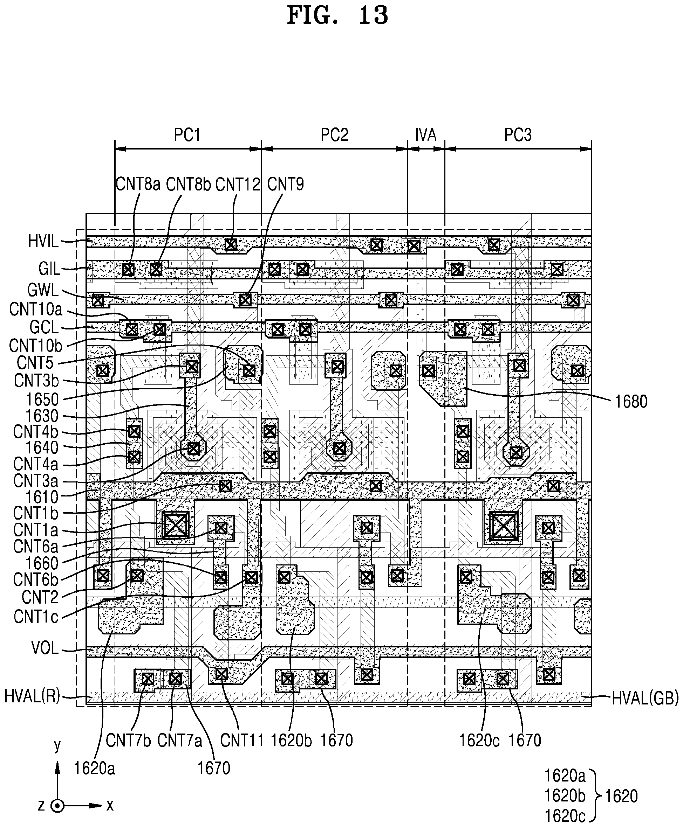

The second interlayer insulating layer 116 (e.g., see FIG. 4) may be disposed on the sixth conductive pattern 1510, the seventh conductive pattern 1520, the repair line RL, and the second-first initialization horizontal voltage line HVAL(R) described above with reference to FIG. 12. Thereafter, as shown in FIG. 13, a voltage transfer line 1610, a first pixel connection electrode 1620, the first connection electrode 1630, a second connection electrode 1640, a third connection electrode 1650, a fourth connection electrode 1660, a fifth connection electrode 1670, the first initialization horizontal voltage line HVIL, the first initialization control line GIL, the scan line GWL, the compensation scan line GCL, and the bias voltage line VOL may be disposed on the second interlayer insulating layer 116.

The voltage transfer line 1610, the first pixel connection electrode 1620, the first connection electrode 1630, the second connection electrode 1640, the third connection electrode 1650, the fourth connection electrode 1660, the fifth connection electrode 1670, the first initialization horizontal voltage line HVIL, the first initialization control line GIL, the scan line GWL, the compensation scan line GCL, and the bias voltage line VOL may include the same material as each other. The voltage transfer line 1610, the first pixel connection electrode 1620, the first connection electrode 1630, the second connection electrode 1640, the third connection electrode 1650, the fourth connection electrode 1660, the fifth connection electrode 1670, the first initialization horizontal voltage line HVIL, the first initialization control line GIL, the scan line GWL, the compensation scan line GCL, and the bias voltage line VOL may include one or more materials selected from among Al, Pt, Pd, Ag, Mg, Au, Ni, Nd, Ir, Cr, Li, Ca, Mo, Ti, W, and/or Cu.

The voltage transfer line 1610 may extend in the first direction (e.g., the ±x direction). The voltage transfer line 1610 may pass through each of the first pixel circuit PC1, the second pixel circuit PC2, and the third pixel circuit PC3. The voltage transfer line 1610 may overlap with the third conductive pattern 1310 (e.g., see FIG. 11). In some embodiments, the voltage transfer line 1610 may comprises a main portion extending in the first direction (e.g., the ±x direction) and overlapping with the third conductive pattern 1310, and branch portions each extending from the main portion along the second direction (e.g. the -y direction). The branch portions may overlap the emission control line EML and/or the repair line RL.

In an embodiment, the voltage transfer line 1610 may have a voltage level of the driving voltage ELVDD (e.g., see FIG. 3). In an embodiment, the voltage transfer line 1610 may be electrically connected to the driving voltage line PL (e.g., see FIG. 14) described in more detail below, and may have the voltage level of the driving voltage ELVDD (e.g., see FIG. 3).

The voltage transfer line 1610 may be electrically connected to the bottom metal layer BML (e.g., see FIG. 7) through a first-first contact hole CNT1a. The voltage transfer line 1610 may be electrically connected to the third conductive pattern 1310 (e.g., see FIG. 12) through a first-second contact hole CNT1b. The voltage transfer line 1610 may be electrically connected to the first silicon semiconductor pattern 1110 (e.g., see FIG. 8) through a first-third contact hole CNT1c. The bottom metal layer BML (e.g., see FIG. 7) may have the voltage level of the driving voltage ELVDD (e.g., see FIG. 3) through the connection structure of the voltage transfer line 1610 and the bottom metal layer BML (e.g., see FIG. 7) through the first-first contact hole CNT1a. The voltage transfer line 1610 may provide the driving voltage ELVDD (e.g., see FIG. 3) to the upper electrode CE2 (e.g., see FIG. 10) of the storage capacitor Cst (e.g., see FIG. 10) and the fifth semiconductor layer A5 (e.g., see FIG. 8) of the operation control transistor T5 (e.g., see FIG. 9) through the first-second contact hole CNT1b and the first-third contact hole CNT1c.

The first pixel connection electrode 1620 may be arranged to be spaced apart from the voltage transfer line 1610. The first pixel connection electrode 1620 may be electrically insulated from the voltage transfer line 1610.

The first pixel connection electrode 1620 may be arranged at (e.g., in or on) the same layer as that of the voltage transfer line 1610. The first pixel connection electrode 1620 may include a first-first pixel connection electrode 1620a, a first-second pixel connection electrode 1620b, and a first-third pixel connection electrode 1620c, which are arranged in the first to third pixel circuits PC1, PC2, and PC3, respectively. Each of the first-first pixel connection electrode 1620a, the first-second pixel connection electrode 1620b, and the first-third pixel connection electrode 1620c may be arranged to be spaced apart from the voltage transfer line 1610.

The first pixel connection electrode 1620 may be electrically connected to the first silicon semiconductor pattern 1110 (e.g., see FIG. 9) through a second contact hole CNT2. For example, the first-first pixel connection electrode 1620a may be electrically connected through the second contact hole CNT2 to the first silicon semiconductor pattern 1110 (e.g., see FIG. 9) corresponding to the first pixel circuit PC1. The first pixel connection electrode 1620 may be electrically connected to the emission control semiconductor layer A6 (e.g., see FIG. 9) of the emission control transistor T6 (e.g., see FIG. 9) formed along the first silicon semiconductor pattern 1110 (e.g., see FIG. 9), and/or the second initialization semiconductor layer A7 (e.g., see FIG. 9) of the second initialization transistor T7 (e.g., see FIG. 9).

Each of the first connection electrode 1630, the second connection electrode 1640, the third connection electrode 1650, the fourth connection electrode 1660, and the fifth connection electrode 1670 may have an isolated shape. Each of the first connection electrode 1630, the second connection electrode 1640, the third connection electrode 1650, the fourth connection electrode 1660, and the fifth connection electrode 1670 may be arranged in each of the first to third pixel circuits PC1, PC2, and PC3.

The first connection electrode 1630 may electrically connect the first conductive pattern 1210 (e.g., see FIG. 9) and the oxide semiconductor pattern 1410 (e.g., see FIG. 11) to each other. The first connection electrode 1630 may be electrically connected to the first conductive pattern 1210 (e.g., see FIG. 9) through a third-first contact hole CNT3a. The first connection electrode 1630 may be electrically connected to the oxide semiconductor pattern 1410 (e.g., see FIG. 11) (e.g., the compensation semiconductor layer A3 (e.g., see FIG. 11) of the compensation transistor T3 (e.g., see FIG. 12)) through a third-second contact hole CNT3b. The first connection electrode 1630 may electrically connect the driving gate electrode G1 (e.g., see FIG. 9) of the driving transistor T1 (e.g., see FIG. 9) and the compensation semiconductor layer A3 (e.g., see FIG. 11) of the compensation transistor T3 (e.g., see FIG. 12) to each other. The first connection electrode 1630 may electrically connect the storage capacitor Cst (e.g., see FIG. 9) and the compensation transistor T3 (e.g., see FIG. 12) to each other.

The first connection electrode 1630 may overlap with a part of the bottom metal layer BML (e.g., see FIG. 9), for example, such as the second branch portion BMLb (e.g., see FIG. 7). This may further increase an integration degree.

The second connection electrode 1640 may electrically connect the first silicon semiconductor pattern 1110 (e.g., see FIG. 9) and the oxide semiconductor pattern 1410 (e.g., see FIG. 12) to each other. The second connection electrode 1640 may be electrically connected to the first silicon semiconductor pattern 1110 (e.g., see FIG. 9) through a fourth-first contact hole CNT4a. The second connection electrode 1640 may be electrically connected to the oxide semiconductor pattern 1410 (e.g., see FIG. 12) through a fourth-second contact hole CNT4b. The second connection electrode 1640 may electrically connect the driving semiconductor layer A1 (e.g., see FIG. 9) of the driving transistor T1 (e.g., see FIG. 9) and the compensation semiconductor layer A3 (e.g., see FIG. 12) of the compensation transistor T3 (e.g., see FIG. 12) to each other. The second connection electrode 1640 may electrically connect the emission control semiconductor layer A6 (e.g., see FIG. 9) of the emission control transistor T6 (e.g., see FIG. 9) and the compensation semiconductor layer A3 (e.g., see FIG. 12) of the compensation transistor T3 (e.g., see FIG. 12) to each other.

The third connection electrode 1650 may be electrically connected to the first silicon semiconductor pattern 1110 (e.g., see FIG. 9) through a fifth contact hole CNT5. For example, the third connection electrode 1650 corresponding to the first pixel circuit PC1 may be further electrically connected to a first data line DL1 described in more detail below with reference to FIG. 14. In other words, the third connection electrode 1650 corresponding to the first pixel circuit PC1 may transfer a data signal applied to the first data line DL1 (e.g., see FIG. 14) to the data write semiconductor layer A2 (e.g., see FIG. 9) of the data write transistor T2 (e.g., see FIG. 9).

The fourth connection electrode 1660 may electrically connect the first silicon semiconductor pattern 1110 (e.g., see FIG. 9) and the second silicon semiconductor pattern 1120 (e.g., see FIG. 9) to each other. The fourth connection electrode 1660 may be electrically connected to the first silicon semiconductor pattern 1110 (e.g., see FIG. 9) through a sixth-first contact hole CNT6a. The fourth connection electrode 1660 may be electrically connected to the second silicon semiconductor pattern 1120 (e.g., see FIG. 9) through a sixth-second contact hole CNT6b. The fourth connection electrode 1660 may electrically connect the operation control semiconductor layer A5 (e.g., see FIG. 9) of the operation control transistor T5 (e.g., see FIG. 9) formed along the first silicon semiconductor pattern 1110 (e.g., see FIG. 9) and the bias semiconductor layer A8 (e.g., see FIG. 9) of the bias transistor T8 (e.g., see FIG. 9) formed along the second silicon semiconductor pattern 1120 (e.g., see FIG. 9) to each other.

The fifth connection electrode 1670 corresponding to the first pixel circuit PC1 may electrically connect the first silicon semiconductor pattern 1110 (e.g., see FIG. 9) corresponding to the first pixel circuit PC1 and the second-first initialization horizontal voltage line HVAL(R) to each other. The fifth connection electrode 1670 corresponding to the first pixel circuit PC1 may electrically connect the second initialization semiconductor layer A7 (e.g., see FIG. 9) of the second initialization transistor T7 (e.g., see FIG. 9) corresponding to the first pixel circuit PC1 formed along the first silicon semiconductor pattern 1110 (e.g., see FIG. 9) and the second-first initialization horizontal voltage line HVAL(R) to each other.

The fifth connection electrode 1670 corresponding to the first pixel circuit PC1 may be electrically connected through a seventh-first contact hole CNT7a to the second initialization semiconductor layer A7 (e.g., see FIG. 9) of the second initialization transistor T7 (e.g., see FIG. 9) corresponding to the first pixel circuit PC1, and may be electrically connected to the second-first initialization horizontal voltage line HVAL(R) through a seventh-second contact hole CNT7b. The second-first initialization horizontal voltage line HVAL(R) may transfer the second-first initialization voltage Vaint(R) (e.g., see FIG. 5) to the second initialization transistor T7 (e.g., see FIG. 9) of the first pixel circuit PC1 through the fifth connection electrode 1670.

The fifth connection electrode 1670 corresponding to each of the second pixel circuit PC2 and the third pixel circuit PC3 may electrically connect the first silicon semiconductor pattern 1110 (e.g., see FIG. 9) and the second-second initialization horizontal voltage line HVAL(GB) respectively corresponding to the second pixel circuit PC2 and the third pixel circuit PC3 to each other. The fifth connection electrode 1670 corresponding to each of the second pixel circuit PC2 and the third pixel circuit PC3 may electrically connect the second initialization semiconductor layer A7 (e.g., see FIG. 9) of the second initialization transistor T7 (e.g., see FIG. 9) corresponding to each of the second pixel circuit PC2 and the third pixel circuit PC3 and the second-second initialization horizontal voltage line HVAL(GB) to each other.

The fifth connection electrode 1670 corresponding to each of the second pixel circuit PC2 and the third pixel circuit PC3 may be electrically connected through the seventh-first contact hole CNT7a to the second initialization semiconductor layer A7 (e.g., see FIG. 9) of the second initialization transistor T7 (e.g., see FIG. 9) corresponding to each of the second pixel circuit PC2 and the third pixel circuit PC3. The fifth connection electrode 1670 corresponding to each of the second pixel circuit PC2 and the third pixel circuit PC3 may be electrically connected to the second-second initialization horizontal voltage line HVAL(GB) through the seventh-second contact hole CNT7b. The second-second initialization horizontal voltage line HVAL(GB) may transfer the second-second initialization voltage Vaint(GB) (e.g., see FIG. 5) to the second initialization transistor T7 (e.g., see FIG. 9) corresponding to each of the second pixel circuit PC2 and the third pixel circuit PC3 through the fifth connection electrode 1670 arranged in each of the second pixel circuit PC2 and the third pixel circuit PC3. In some embodiments, the second-first initialization voltage Vaint(R) (e.g., see FIG. 5) and the second-second initialization voltage Vaint(GB) (e.g., see FIG. 5) may have the same voltage level as each other.

Each of the first initialization control line GIL, the scan line GWL, the compensation scan line GCL, the bias voltage line VOL, and the first initialization horizontal voltage line HVIL may extend in the first direction (e.g., the ±x direction).

The first initialization control line GIL may be electrically connected to the fifth conductive pattern 1330 (e.g., see FIG. 12) and the seventh conductive pattern 1520 (e.g., see FIG. 12) of each of the first to third pixel circuits PC1, PC2, and PC3. The first initialization control line GIL may be electrically connected to the fifth conductive pattern 1330 (e.g., see FIG. 12) of each of the first to third pixel circuits PC1, PC2, and PC3 through an eighth-first contact hole CNT8a. The first initialization control line GIL may be electrically connected to the seventh conductive pattern 1520 (e.g., see FIG. 12) of each of the first to third pixel circuits PC1, PC2, and PC3 through an eighth-second contact hole CNT8b. The first initialization control line GIL may provide the first initialization control signal GI (e.g., see FIG. 3) to each of the fifth conductive pattern 1330 (e.g., see FIG. 12), which is the lower first initialization gate electrode G4a (e.g., see FIG. 12) of the first initialization transistor T4 (e.g., see FIG. 12), and the seventh conductive pattern 1520 (e.g., see FIG. 12), which is the upper first initialization gate electrode G4b (e.g., see FIG. 12) of the first initialization transistor T4 (e.g., see FIG. 12).

The scan line GWL may be electrically connected to the second conductive pattern 1220 (e.g., see FIG. 9) of each of the first to third pixel circuits PC1, PC2, and PC3 through a ninth contact hole CNT9. The scan line GWL may provide the scan signal GW (e.g., see FIG. 3) to the second conductive pattern 1220 (e.g., see FIG. 9), which is the data write gate electrode G2 (e.g., see FIG. 9) of the data write transistor T2 (e.g., see FIG. 9) of each of the first to third pixel circuits PC1, PC2, and PC3.

The compensation scan line GCL may be electrically connected to the fourth conductive pattern 1320 (e.g., see FIG. 12) and the sixth conductive pattern 1510 (e.g., see FIG. 12) of each of the first to third pixel circuits PC1, PC2, and PC3. The compensation scan line GCL may be electrically connected to the fourth conductive pattern 1320 (e.g., see FIG. 12) of each of the first to third pixel circuits PC1, PC2, and PC3 through a tenth-first contact hole CNT10a. The compensation scan line GCL may be electrically connected to the sixth conductive pattern 1510 (e.g., see FIG. 12) of each of the first to third pixel circuits PC1, PC2, and PC3 through a tenth-second contact hole CNT10b. The compensation scan line GCL may provide the compensation scan signal GC (e.g., see FIG. 3) to each of the fourth conductive pattern 1320 (e.g., see FIG. 12), which is the lower compensation gate electrode G3a (e.g., see FIG. 12) of the compensation transistor T3 (e.g., see FIG. 12), and the sixth conductive pattern 1510 (e.g., see FIG. 12), which is the upper compensation gate electrode G3b (e.g., see FIG. 12) of the compensation transistor T3 (e.g., see FIG. 12).

The bias voltage line VOL may be electrically connected to the second silicon semiconductor pattern 1120 (e.g., see FIG. 9) of each of the first to third pixel circuits PC1, PC2, and PC3 through an eleventh contact hole CNT11. The bias voltage line VOL may provide the bias voltage Vobs (e.g., see FIG. 3) to the bias semiconductor layer A8 (e.g., see FIG. 9) of the bias transistor T8 (e.g., see FIG. 9) of each of the first to third pixel circuits PC1, PC2, and PC3.

The first initialization horizontal voltage line HVIL may be electrically connected to the oxide semiconductor pattern 1410 (e.g., see FIG. 11) of each of the first to third pixel circuits PC1, PC2, and PC3 through a twelfth contact hole CNT12. In other words, the first initialization voltage Vint (e.g., see FIG. 3) may be provided to the first initialization semiconductor layer A4 (e.g., see FIG. 12) of the first initialization transistor T4 (e.g., see FIG. 12) formed along the oxide semiconductor pattern 1410 (e.g., see FIG. 11).

After the first organic insulating layer 121 (e.g., see FIG. 4) is disposed on the structure described above with reference to FIG. 13, as shown in FIG. 14, a second pixel connection electrode 1710, the driving voltage line PL, the first data line DL1, a second data line DL2, a third data line DL3, and the vertical voltage line VCL may be disposed on the first organic insulating layer 121.

Referring to FIG. 14, each of the driving voltage line PL, the first data line DL1, the second data line DL2, the third data line DL3, and the vertical voltage line VCL may extend in the second direction (e.g., the ±y direction). The driving voltage line PL, the first data line DL1, the second data line DL2, the third data line DL3, the vertical voltage line VCL, and the second pixel connection electrode 1710 may include the same material as each other.

The driving voltage line PL, the first data line DL1, the second data line DL2, the third data line DL3, the vertical voltage line VCL, and the second pixel connection electrode 1710 may include one or more materials selected from among Al, Pt, Pd, Ag, Mg, Au, Ni, Nd, Ir, Cr, Li, Ca, Mo, Ti, W, and Cu.

The driving voltage line PL may be arranged in each of the first to third pixel circuits PC1, PC2, and PC3. The driving voltage line PL corresponding to one of the first to third pixel circuits PC1, PC2, and PC3 may be electrically connected to the voltage transfer line 1610 (e.g., see FIG. 13) through a 14^{th} contact hole CNT14. Shapes and areas of the driving voltage line PL arranged in each of the first to third pixel circuits PC1, PC2, and PC3 may be different from the others.

The driving voltage line PL arranged in each of the first to third pixel circuits PC1, PC2, and PC3 may overlap with the gate electrode of the compensation transistor T3 (e.g., see FIG. 12) of each of the first to third pixel circuits PC1, PC2, and PC3 (e.g., the upper compensation gate electrode G3b and the lower compensation gate electrode G3a of FIG. 12), may overlap with the gate electrode of the first initialization transistor T4 (e.g., see FIG. 12) of each of the first to third pixel circuits PC1, PC2, and PC3 (e.g., the upper first initialization gate electrode G4b and the lower first initialization gate electrode G4a of FIG. 12), and may overlap with the first connection electrode 1630 (e.g., see FIG. 13) corresponding to each of the first to third pixel circuits PC1, PC2, and PC3. The first connection electrode 1630 (e.g., see FIG. 13) may connect the compensation semiconductor layer A3 (e.g., see FIG. 12) of the compensation transistor T3 (e.g., see FIG. 12) and the driving gate electrode G1 (e.g., see FIG. 9) of the driving transistor T1 (e.g., see FIG. 9) to each other. Through the overlapping structure described above, a parasitic capacitance may be prevented or substantially prevented from affecting the compensation transistor T3 (e.g., see FIG. 12) and the first connection electrode 1630 (e.g., see FIG. 13). When viewed on the plane shown in FIG. 14 (e.g., in a plan view), the first connection electrode 1630 (e.g., see FIG. 13) overlaps with the second branch portion BMLb (e.g., see FIG. 7) of the bottom metal layer BML (e.g., see FIG. 7) and the driving voltage line PL having a voltage level (e.g., a voltage level of the driving voltage ELVDD (e.g., see FIG. 3)) of the same constant or substantially constant voltage, thereby more effectively preventing the parasitic capacitance described above.

The first data line DL1, the second data line DL2, and the third data line DL3 may be electrically connected to the data write transistors T2 (e.g., see FIG. 9) of the first pixel circuit PC1, the second pixel circuit PC2, and the third pixel circuit PC3, respectively. The first to third data lines DL1, DL2, and DL3 may transfer the data signal Dm (e.g., see FIG. 3) to the first to third pixel circuits PC1, PC2, and PC3, respectively.

The first data line DL1 may be electrically connected to the third connection electrode 1650 (e.g., see FIG. 13) corresponding to the first pixel circuit PC1 through a 15^{th} contact hole CNT15. Similarly, the second data line DL2 may be electrically connected to the third connection electrode 1650 (e.g., see FIG. 13) corresponding to the second pixel circuit PC2 through a 15^{th} contact hole CNT15, and the third data line DL3 may be electrically connected to the third connection electrode 1650 (e.g., see FIG. 13) corresponding to the third pixel circuit PC3 through a 15^{th} contact hole CNT15. The third connection electrode 1650 (e.g., see FIG. 13) corresponding to each of the first to third pixel circuits PC1, PC2, and PC3 is electrically connected to the first silicon semiconductor pattern 1110 (e.g., see FIG. 8) of the corresponding pixel circuit, and thus, may provide the data signal Dm (e.g., see FIG. 3) to the data write semiconductor layer A2 (e.g., see FIG. 9) of the data write transistor T2 (e.g., see FIG. 9) formed along the first silicon semiconductor pattern 1110 (e.g., see FIG. 8).

A shape of each of the first data line DL1, the second data line DL2, and the third data line DL3 in a plan view may be different from each other. For example, the first data line DL1 and the second data line DL2 may have different planar shapes from each other, and may pass through an area corresponding to the second pixel circuit PC2. For example, the first data line DL1 and the second data line DL2 may be asymmetrical with each other with respect to an imaginary line extending in the second direction (e.g., the ±y direction) between the first data line DL1 and the second data line DL2. A planar shape of the third data line DL3 may be different from the planar shape of each of the first data line DL1 and the second data line DL2.

In a plan view, each of the first data line DL1, the second data line DL2, and the third data line DL3 may cross the second-first initialization horizontal voltage line HVAL(R) (e.g., see FIG. 13) and the second-second initialization horizontal voltage line HVAL(GB) (e.g., see FIG. 13).

The vertical voltage line VCL may be arranged in a separation space IVA between the second pixel circuit PC2 and the third pixel circuit PC3. For example, the vertical voltage line VCL may be arranged between the second data line DL2 and the driving voltage line PL of the third pixel circuit PC3.

The vertical voltage line VCL may be electrically connected to a voltage line extending in the first direction (e.g., the ±x direction). In an embodiment, FIG. 14 shows that the vertical voltage line VCL is connected to a sixth connection electrode 1680 through a contact hole CNT-VC1, the sixth connection electrode 1680 is connected through a contact hole CNT-VC2 to the bridge pattern 1340 disposed immediately thereunder, and the bridge pattern 1340 is electrically connected to the first initialization horizontal voltage line HVIL (e.g., see FIG. 13) through a contact hole CNT-VC3.

The second pixel connection electrode 1710 may be electrically connected to the first pixel connection electrode 1620 (e.g., see FIG. 13). For example, a second-first pixel connection electrode 1710a may be electrically connected to the first-first pixel connection electrode 1620a (e.g., see FIG. 13) through a 13^{th}-first contact hole CNT13a. For example, a second-second pixel connection electrode 1710b may be electrically connected to the first-second pixel connection electrode 1620b (e.g., see FIG. 13) through a 13^{th}-second contact hole CNT13b. For example, a second-third pixel connection electrode 1710c may be electrically connected to the first-third pixel connection electrode 1620c (e.g., see FIG. 13) through a 13^{th}-third contact hole CNT13c.

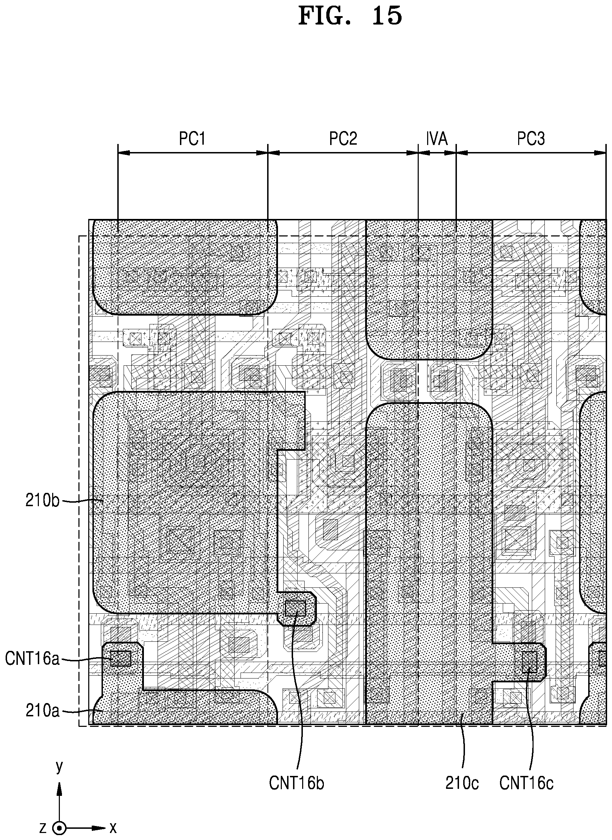

The second organic insulating layer 123 (e.g., see FIG. 4) may be disposed on the structure described above with reference to FIG. 14. Thereafter, the pixel electrodes 210a, 210b, and 210c as shown in FIG. 15 may be disposed on the second organic insulating layer 123 (e.g., see FIG. 4).

Referring to FIG. 15, a first pixel electrode 210a electrically connected to the first pixel circuit PC1, a second pixel electrode 210b electrically connected to the second pixel circuit PC2, and a third pixel electrode 210c electrically connected to the third pixel circuit PC3 may be arranged to be spaced apart from each other. In an embodiment, the first pixel electrode 210a and the second pixel electrode 210b may be arranged in the same column as each other in the second direction (e.g., the y direction), and may be alternately arranged. The third pixel electrode 210c may be arranged in a column adjacent to the column in which the first pixel electrode 210a and the second pixel electrode 210b are arranged.

The pixel electrodes 210a, 210b, and 210c may be electrically connected to the first to third pixel circuits PC1, PC2, and PC3, respectively, through the second pixel connection electrode 1710 (e.g., see FIG. 14) and the first pixel connection electrode 1620 (e.g., see FIG. 13). The first pixel electrode 210a may be connected to the second-first pixel connection electrode 1710a (e.g., see FIG. 14) through a 16^{th}-first contact hole CNT16a, and the second-first pixel connection electrode 1710a may be electrically connected to the first-first pixel connection electrode 1620a (e.g., see FIG. 13) through the 13^{th}-first contact hole CNT13a (e.g., see FIG. 14). The second pixel electrode 210b may be connected to the second-second pixel connection electrode 1710b (e.g., see FIG. 14) through a 16^{th}-second contact hole CNT16b, and the second-second pixel connection electrode 1710b (e.g., see FIG. 14) may be electrically connected to the first-second pixel connection electrode 1620b (e.g., see FIG. 13) through the 13^{th}-second contact hole CNT13b (e.g., see FIG. 14). The third pixel electrode 210c may be connected to the second-third pixel connection electrode 1710c (e.g., see FIG. 14) through a 16^{th}-third contact hole CNT16c, and the second-third pixel connection electrode 1710c (e.g., see FIG. 14) may be electrically connected to the first-third pixel connection electrode 1620c (e.g., see FIG. 13) through the 13^{th}-third contact hole CNT13c (e.g., see FIG. 14).

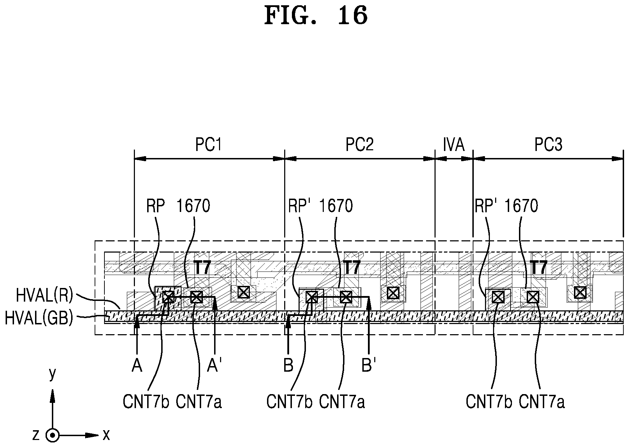

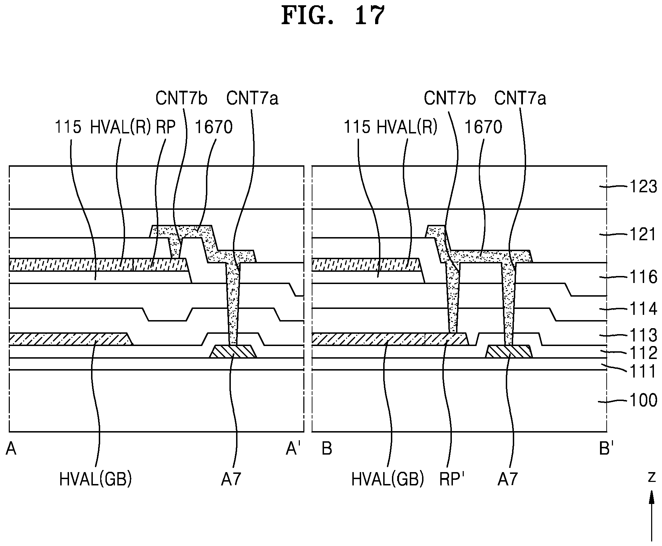

FIG. 16 is a plan view schematically illustrating second initialization horizontal voltage lines passing through the first to third pixel circuits PC1, PC2, and PC3 of a display device, according to an embodiment. FIG. 17 is a cross-sectional view taken along the lines A-A' and B-B' of FIG. 16.

Referring to FIG. 16, the second-first initialization horizontal voltage line HVAL(R) and the second-second initialization horizontal voltage line HVAL(GB) may overlap with each other, and may extend in the first direction (e.g., the ±x direction). For example, as shown in FIGS. 16 and 17, the second-first initialization horizontal voltage line HVAL(R) may be disposed over the second-second initialization horizontal voltage line HVAL(GB), and may overlap with the second-second initialization horizontal voltage line HVAL(GB). The second-second initialization horizontal voltage line HVAL(GB) and the second-first initialization horizontal voltage line HVAL(R) may have a voltage level of constant or substantially constant voltage. For example, the second-second initialization horizontal voltage line HVAL(GB) and the second-first initialization horizontal voltage line HVAL(R) may have the same or similar voltage level as each other. Because the second-second initialization horizontal voltage line HVAL(GB) and the second-first initialization horizontal voltage line HVAL(R) having the same or similar voltage level as each other may be arranged to overlap with each other, a space may be more efficiently used (e.g., a degree of integration may be improved), while minimizing or reducing the occurrence of a parasitic capacitance between electrodes of the transistors, the voltage lines, and/or the signal lines of the first to third pixel circuits PC1, PC2, and PC3 in a limited space. Insulating layers (e.g., the second gate insulating layer 113, the first interlayer insulating layer 114, and the third gate insulating layer 115) may be located between the second-first initialization horizontal voltage line HVAL(R) and the second-second initialization horizontal voltage line HVAL(GB).

The second-first initialization horizontal voltage line HVAL(R) and the second-second initialization horizontal voltage line HVAL(GB) may be electrically connected to the second initialization transistors T7 of different pixel circuits from each other. In an embodiment, the second-first initialization horizontal voltage line HVAL(R) may be electrically connected to the second initialization transistor T7 of the first pixel circuit PC1, and the second-second initialization horizontal voltage line HVAL(GB) may be electrically connected to the second initialization transistor T7 of each of the second and third pixel circuits PC2 and PC3.

Referring to the line A-A' of FIGS. 16 and 17, the second-first initialization horizontal voltage line HVAL(R) may be electrically connected to the second initialization transistor T7 corresponding to the first pixel circuit PC1. The second-first initialization horizontal voltage line HVAL(R) may include a protrusion RP in the second direction (e.g., the ±y direction). In a plan view, the fifth connection electrode 1670 may have an isolated shape, and may overlap with the protrusion RP of the second-first initialization horizontal voltage line HVAL(R) and the second initialization semiconductor layer A7.

The fifth connection electrode 1670 may be electrically connected to the second initialization semiconductor layer A7 of the second initialization transistor T7 through the seventh-first contact hole CNT7a passing through the first gate insulating layer 112, the second gate insulating layer 113, the first interlayer insulating layer 114, and the second interlayer insulating layer 116 and may be electrically connected to the protrusion RP of the second-first initialization horizontal voltage line HVAL(R) through the seventh-second contact hole CNT7b passing through the second interlayer insulating layer 116.

Referring to the line B-B' of FIGS. 16 and 17, the second-second initialization horizontal voltage line HVAL(GB) may be electrically connected to the second initialization transistor T7 corresponding to each of the second pixel circuit PC2 and the third pixel circuit PC3. The second-second initialization horizontal voltage line HVAL(GB) may include a protrusion RP' in the second direction (e.g., the ±y direction). In a plan view, the fifth connection electrode 1670 corresponding to each of the second pixel circuit PC2 and the third pixel circuit PC3 may have an isolated shape, and may overlap with the protrusion RP' of the second-second initialization horizontal voltage line HVAL(GB) and the second initialization semiconductor layer A7.

The fifth connection electrode 1670 may be electrically connected to the second initialization semiconductor layer A7 of the second initialization transistor T7 corresponding to the second pixel circuit PC2 through the seventh-first contact hole CNT7a passing through the first gate insulating layer 112, the second gate insulating layer 113, the first interlayer insulating layer 114, and the second interlayer insulating layer 116. The fifth connection electrode 1670 may be electrically connected to the protrusion RP' of the second-second initialization horizontal voltage line HVAL(GB) through the seventh-second contact hole CNT7b passing through the second gate insulating layer 113, the first interlayer insulating layer 114, and the second interlayer insulating layer 116.

The line B-B' of FIG. 17 shows that the second-second initialization horizontal voltage line HVAL(GB) and the second initialization transistor T7 corresponding to the second pixel circuit PC2 are electrically connected to each other through the fifth connection electrode 1670. However, the present disclosure is not limited thereto. An electrical connection structure of the second-second initialization horizontal voltage line HVAL(GB) and the second initialization transistor T7 corresponding to the third pixel circuit PC3 may have the same or substantially the same structure as the structure described above with reference to the line B-B' of FIG. 17.

According to an embodiment, one of the first to third pixel circuits PC1, PC2, and PC3 is connected to another (e.g. the other) different second initialization horizontal voltage line, thereby effectively implementing a black image of the first to third light-emitting diodes having different emission characteristics, and improving a power consumption.

In some embodiments, the second-first initialization voltage Vaint(R) (e.g., see FIG. 5) provided through the second-first initialization horizontal voltage line HVAL(R) and the second-second initialization voltage Vaint(GB) (e.g., see FIG. 5) provided through the second-second initialization horizontal voltage line HVAL(GB) may be greater than the common voltage ELVSS (e.g., see FIG. 3), and a difference between the second-first initialization voltage Vaint(R) (e.g., see FIG. 5) and the common voltage ELVSS (e.g., see FIG. 3) may be about +1.2 V to about +1.8 V. In some embodiments, the second-first initialization voltage Vaint(R) (e.g., see FIG. 5) provided through the second-first initialization horizontal voltage line HVAL(R) may be greater than the second-second initialization voltage Vaint(GB) (e.g., see FIG. 5) provided through the second-second initialization horizontal voltage line HVAL(GB). In another embodiment, the second-first initialization voltage Vaint(R) (e.g., see FIG. 5) provided through the second-first initialization horizontal voltage line HVAL(R) and the second-second initialization voltage Vaint(GB) (e.g., see FIG. 5) provided through the second-second initialization horizontal voltage line HVAL(GB) may be equal to each other. In another embodiment, the second-first initialization voltage Vaint(R) (e.g., see FIG. 5) provided through the second-first initialization horizontal voltage line HVAL(R) may be less than the second-second initialization voltage Vaint(GB) (e.g., see FIG. 5) provided through the second-second initialization horizontal voltage line HVAL(GB).

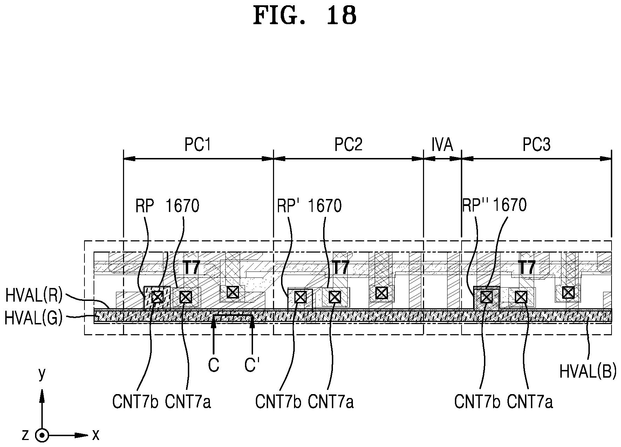

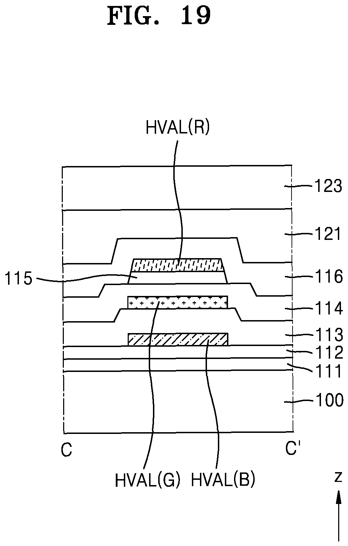

FIG. 18 is a plan view schematically illustrating initialization horizontal voltage lines passing through the first to third pixel circuits of a display device, according to an embodiment. FIG. 19 is a cross-sectional view taken along the line C-C' of FIG. 18.

In the display device described above with reference to FIGS. 6 to 17, one of the first to third pixel circuits PC1, PC2, and PC3 may be electrically connected to the second-first initialization horizontal voltage line HVAL(R), and the other remaining pixel circuits are electrically connected to the second-second initialization horizontal voltage line HVAL(GB). However, the present disclosure is not limited thereto.

In another embodiment, referring to FIG. 18, the second-first initialization horizontal voltage line HVAL(R) (also referred to as "a first horizontal voltage line"), a second-second initialization horizontal voltage line HVAL(G) (also referred to as "a second horizontal voltage line"), and a second-third initialization horizontal voltage line HVAL(B) (also referred to as "a third horizontal voltage line") may overlap with each other, and may extend in the first direction (e.g., the ±x direction.

For example, as shown in FIG. 19, the second-first initialization horizontal voltage line HVAL(R) may be disposed over the second-second initialization horizontal voltage line HVAL(G), and the second-second initialization horizontal voltage line HVAL(G) may be disposed over the second-third initialization horizontal voltage line HVAL(B). Thus, a space may be more efficiently used, while minimizing or reducing the occurrence of a parasitic capacitance between electrodes of the transistors, the voltage lines, and/or the signal lines of the first to third pixel circuits PC1, PC2, and PC3 in a limited space. In some embodiments, the first interlayer insulating layer 114 and the third gate insulating layer 115 may be located between the second-first initialization horizontal voltage line HVAL(R) and the second-second initialization horizontal voltage line HVAL(G). The second gate insulating layer 113 may be located between the second-second initialization horizontal voltage line HVAL(G) and the second-third initialization horizontal voltage line HVAL(B).

The second-first initialization horizontal voltage line HVAL(R), the second-second initialization horizontal voltage line HVAL(G), and the second-third initialization horizontal voltage line HVAL(B) may be electrically connected to the second initialization transistors T7 of different pixel circuits from each other.

Referring to FIG. 18, the second-first initialization horizontal voltage line HVAL(R) may be electrically connected to the second initialization transistor T7 corresponding to the first pixel circuit PC1. The second-first initialization horizontal voltage line HVAL(R) may include a protrusion RP in the second direction (e.g., the ±y direction). The fifth connection electrode 1670 corresponding to the first pixel circuit PC1 may have an isolated shape in a plan view, and may overlap with the protrusion RP of the second-first initialization horizontal voltage line HVAL(R) and the second initialization semiconductor layer A7 (e.g., see FIG. 8) of the second initialization transistor T7 corresponding to the first pixel circuit PC1. The fifth connection electrode 1670 corresponding to the first pixel circuit PC1 may be connected to the protrusion RP of the second-first initialization horizontal voltage line HVAL(R) and the second initialization semiconductor layer A7 (e.g., see FIG. 8) of the second initialization transistor T7 through a seventh-second contact hole CNT7b and a seventh- first contact hole CNT7a, respectively.

The second-second initialization horizontal voltage line HVAL(G) may be electrically connected to the second initialization transistor T7 of the second pixel circuit PC2. The second-second initialization horizontal voltage line HVAL(G) may include the protrusion RP' in the second direction (e.g., the ±y direction). The fifth connection electrode 1670 corresponding to the second pixel circuit PC2 may have an isolated shape in a plan view, and may overlap with the protrusion RP' of the second-second initialization horizontal voltage line HVAL(G) and the second initialization semiconductor layer A7 (e.g., see FIG. 8) of the second initialization transistor T7 corresponding to the second pixel circuit PC2. The fifth connection electrode 1670 corresponding to the second pixel circuit PC2 may be connected to the protrusion RP' of the second-second initialization horizontal voltage line HVAL(G) and the second initialization semiconductor layer A7 (e.g., see FIG. 8) of the second initialization transistor T7 through the seventh-second contact hole CNT7b and the seventh-first contact hole CNT7a, respectively.

The second-third initialization horizontal voltage line HVAL(B) may be electrically connected to the second initialization transistor T7 of the third pixel circuit PC3. The second-third initialization horizontal voltage line HVAL(B) may include a protrusion RP" in the second direction (e.g., the ±y direction). The fifth connection electrode 1670 corresponding to the third pixel circuit PC3 may have an isolated shape in a plan view, and may overlap with the protrusion RP" of the second-third initialization horizontal voltage line HVAL(B) and the second initialization semiconductor layer A7 (e.g., see FIG. 8) of the second initialization transistor T7 corresponding to the third pixel circuit PC3. The fifth connection electrode 1670 corresponding to the third pixel circuit PC3 may be connected to the protrusion RP" of the second-third initialization horizontal voltage line HVAL(B) and the second initialization semiconductor layer A7 (e.g., see FIG. 8) of the second initialization transistor T7 through the seventh-second contact hole CNT7b and the seventh-first contact hole CNT7a, respectively.

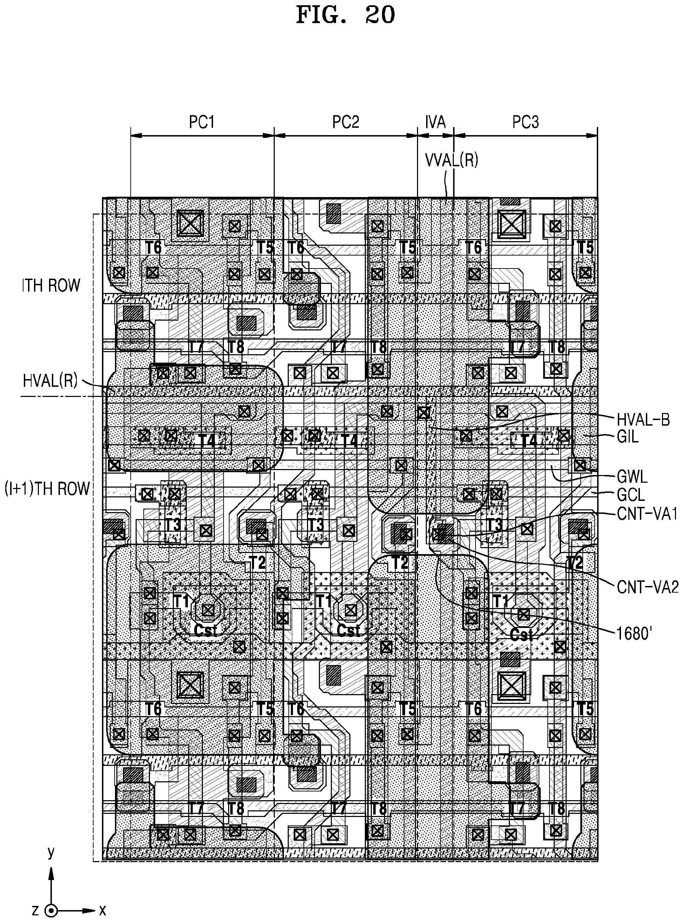

FIG. 20 is a plan view showing an electrical connection between a second initialization horizontal voltage line and a second initialization vertical voltage line of a display device, according to an embodiment.

Referring to FIG. 20, the second-first initialization horizontal voltage line HVAL(R) passes through the first to third pixel circuits PC1, PC2, and PC3 arranged in an i^{th} row, and may be electrically connected to the second-first initialization vertical voltage line VVAL(R) (also referred to as "a first vertical voltage line") passing through the separation space IVA between the second pixel circuit PC2 and the third pixel circuit PC3.

The second-first initialization horizontal voltage line HVAL(R) may include a bridge portion HVAL-B extending toward an (i+1)^{th} row in the second direction (e.g., the ±y direction). The bridge portion HVAL-B may be integrally provided with the second-first initialization horizontal voltage line HVAL(R) by using the same material as each other. The bridge portion HVAL-B may be positioned in (e.g., within) the separation space IVA between the second pixel circuit PC2 and the third pixel circuit PC3, which are arranged in the (i+1)^{th} row. In FIG. 20, the bridge portion HVAL-B is integrated with the second-first initialization horizontal voltage line HVAL(R). However, the present disclosure is not limited thereto. In another embodiment, the bridge portion HVAL-B may be disposed at (e.g., in or on) a layer different from a layer of the second-first initialization horizontal voltage line HVAL(R), and may be connected to the second-first initialization horizontal voltage line HVAL(R) through a contact hole passing through an insulating layer between the second-first initialization horizontal voltage line HVAL(R) and the bridge portion HVAL-B. In this case, a vertical distance (e.g., in a direction away from an upper surface of a substrate in a +z direction) from lines crossing the bridge portion HVAL-B (e.g., signal lines, such as the first initialization control line GIL, the scan line GWL, and/or the compensation scan line GCL) may be increased, and a coupling between the first initialization control line GIL, the scan line GWL, and/or the compensation scan line GCL and the bridge portion HVAL-B may be minimized or prevented.

The second-first initialization vertical voltage line VVAL(R) may be electrically connected to the bridge portion HVAL-B of the second-first initialization horizontal voltage line HVAL(R). For example, the second-first initialization vertical voltage line VVAL(R) and the bridge portion HVAL-B of the second-first initialization horizontal voltage line HVAL(R) may be electrically connected to each other through a connection electrode 1680' overlapping with a part of the bridge portion HVAL-B and a part of the second-first initialization vertical voltage line VVAL(R). For example, the connection electrode 1680' may be connected to the bridge portion HVAL-B through a contact hole CNT-VA1, and the second-first initialization vertical voltage line VVAL(R) may be connected to the connection electrode 1680' through a contact hole CNT-VA2.

FIG. 20 shows an electrical connection between the second-first initialization horizontal voltage line HVAL(R) and the second-first initialization vertical voltage line VVAL(R), but the present disclosure is not limited thereto. The second-second initialization horizontal voltage line HVAL(GB) described above with reference to FIG. 16 may include a bridge portion extending toward the (i+1)^{th} row, and the bridge portion of the second-second initialization horizontal voltage line HVAL(GB) may be electrically connected to the second-second initialization vertical voltage line VVAL(GB) (e.g., see FIG. 5) passing through the separation space IVA.

According to some embodiments, an integration degree of a pixel circuit may be improved, and an unwanted parasitic capacitance may be minimized or reduced, thereby providing a high-quality display device. However, the present disclosure is not limited to the above aspects and features.

The foregoing is illustrative of some embodiments of the present disclosure, and is not to be construed as limiting thereof. Although some embodiments have been described, those skilled in the art will readily appreciate that various modifications are possible in the embodiments without departing from the spirit and scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims.

## Claims

1. A display panel comprising:
a first pixel circuit (PC1) and a second pixel circuit (PC2) adjacent to each other in a first direction (x), each of the first and second pixel circuits (PC1, PC2) comprising a driving transistor (T1) and a first capacitor (Cst) on a substrate (100);
a first light-emitting diode electrically connected to the first pixel circuit (PC1);
a second light-emitting diode electrically connected to the second pixel circuit (PC2);
a first horizontal voltage line (HVAL(R)) extending in the first direction (x), and electrically connected to a semiconductor layer of a first transistor (T7), the semiconductor layer of the first transistor (T7) being electrically connected to the driving transistor (T1) of the first pixel circuit (PC1) and a pixel electrode of the first light-emitting diode;
a second horizontal voltage line (HVAL(GB)) extending in the first direction (x), and electrically connected to a semiconductor layer of a second transistor (T7), the semiconductor layer of the second transistor (T7) being electrically connected to the driving transistor (T1) of the second pixel circuit (PC2) and a pixel electrode of the second light-emitting diode; and
a first gate line (GBL) extending in the first direction (x), and electrically connected to each of a gate electrode of the first transistor (T7) of the first pixel circuit (PC1) and a gate electrode of the second transistor (T7) of the second pixel circuit (PC2),
wherein the first horizontal voltage line (HVAL(R)) and the second horizontal voltage line (HVAL(GB)) are at different layers from each other, and overlap with each other in a plan view.

2. The display panel of claim 1, wherein the second horizontal voltage line (HVAL(GB)) is at a same layer as that of the first gate line (GBL).

3. The display panel of any one of the preceding claims 1 to 2, further comprising a bottom metal layer (BML) between an upper surface of the substrate (100) and the driving transistor (T1) of the first pixel circuit (PC1), and between the upper surface of the substrate (100) and the driving transistor (T1) of the second pixel circuit (PC2), the bottom metal layer (BML) comprising:
a first main portion (BMLc) overlapping with a channel region of the driving transistor (T1) of the first pixel circuit (PC1);
a second main portion (PMLc) overlapping with a channel region of the driving transistor of the second pixel circuit (PC2);
a first branch portion (BMLa) extending in the first direction (x) to connect the first main portion (BMLc) and the second main portion (BMLc) to each other; and
second branch portions (BMLb) connected to the first main portion (BMLc) and the second main portion (BMLc), respectively, and extending in a second direction (y) crossing the first direction (x).

4. The display panel of claim 3, wherein, in the plan view, the second branch portions (BMLb) cross the first horizontal voltage line (HVAL(R)) and the second horizontal voltage line (HVAL(GB)).

5. The display panel of any one of the preceding claims 3 to **4,** further comprising a horizontal driving voltage line (1310) extending in the first direction (x), and overlapping with the driving transistor (T1) of the first pixel circuit (P1) and the driving transistor (T1) of the second pixel circuit (P2),
wherein the horizontal driving voltage line (1310) overlaps with the first branch portion (BMLa).

6. The display panel of any one of the preceding claims 3 to 5, wherein each of the first pixel circuit (P1) and the second pixel circuit (P2) further comprises a compensation transistor (T3) electrically connected to the driving transistor (T1), and comprising a compensation semiconductor layer (A3) and a compensation gate electrode (G3a, G3b), and
wherein the first horizontal voltage line (HVAL(R)) is located at a same layer as that of the compensation gate electrode (G3a, G3b) of the compensation transistor (T3).

7. The display panel of claim 6, further comprising a first connection electrode (1630) electrically connecting the compensation semiconductor layer (A3) of the compensation transistor (T3) of the first pixel circuit (PC1) and a driving gate electrode (G1) of the driving transistor (T1) of the first pixel circuit (PC1) to each other,
wherein the first connection electrode (1630) overlaps with one of the second branch portions (BMLb) of the bottom metal layer (BML).

8. The display panel of claim 7, further comprising a driving voltage line (PL) extending in the second direction (y) to pass through the first pixel circuit (PC1).

9. The display panel of claim 8, wherein the driving voltage line (PL) overlaps with the first connection electrode (1630) and the one of the second branch portions (BMLb) of the bottom metal layer (BML) corresponding to the first pixel circuit (PC1).

10. The display panel of any one of the preceding claims 8 to 9, wherein, in the plan view, the driving voltage line (PL) overlaps with the compensation gate electrode (G3a, G3b) of the compensation transistor (T3) of the first pixel circuit (PC1), and/or,
wherein the first pixel circuit (PC1) further comprises a first initialization transistor (T4) comprising a first initialization semiconductor layer (A4) and a first initialization gate electrode (G4a, G4b), the first initialization semiconductor layer (A4) being integrally connected to the compensation semiconductor layer (A3) of the compensation transistor (T3), and
wherein the driving voltage line (PL) overlaps with the first initialization gate electrode (G4a, G4b).

11. The display panel of any one of the preceding claims 1 to 10, further comprising a third pixel circuit (PC3) located on an opposite side of the first pixel circuit (PC1) with respect to the second pixel circuit (PC2),
wherein a first spaced distance (DS1) between the driving transistor (T1) of the second pixel circuit (PC2) and a driving transistor (T1) of the third pixel circuit is greater than a second spaced distance (DS2) between the driving transistor (T1) of the second pixel circuit (PC2) and the driving transistor (T1) of the first pixel circuit (PC1).

12. The display panel of claim 11, wherein a planar shape of a channel region of the driving transistor (T1) of the third pixel circuit (PC3) is different from at least one of a planar shape of a channel region of the driving transistor (T1) of the second pixel circuit (PC2) or a planar shape of a channel region of the driving transistor (T1) of the first pixel circuit (PC1),
and/or,
wherein the third pixel circuit (PC3) further comprises a third transistor (TR7) electrically connected to the driving transistor (T1) of the third pixel circuit (PC3),
wherein a pixel electrode of a third light-emitting diode (LED) is electrically connected to the third pixel circuit (PC3), and
wherein the second horizontal voltage line (HVAL(GB)) is electrically connected to the third transistor (TR7) of the third pixel circuit (PC3).

13. The display panel of any one of the preceding claims 11 to 12, wherein the third pixel circuit (PC3) further comprises a third transistor (T7) electrically connected to the driving transistor (T1) of the third pixel circuit (PC3),
wherein a pixel electrode of a third light-emitting diode (LED) is electrically connected to the third pixel circuit (PC3), and
wherein a third horizontal voltage line (HVAL(B)) electrically connected to the third transistor (T7) of the third pixel circuit (PC3) is located at a layer different from those of the first horizontal voltage line (HVAL(R)) and the second horizontal voltage line (HVAL(GB)), and overlaps with the first horizontal voltage line (HVAL(R)) and the second horizontal voltage line (HVAL(GB)).

14. The display panel of any one of the preceding claims 11 to 13, further comprising a first vertical voltage line (VVAL(R)) extending in a second direction (y) crossing the first direction (x), and passing through a separation space (IVA) having the first spaced distance between the second pixel circuit (PC2) and the third pixel circuit (PC3),
wherein the first horizontal voltage line (HVAL(R)) is electrically connected to the first vertical voltage line (VVAL(R)).

15. The display panel of claim **14,** wherein the first horizontal voltage line (HVAL(R)) further comprises a bridge portion (HVAL-B) protruding from the first horizontal voltage line (HVAL(R)), and
wherein the bridge portion (HVAL-B) is electrically connected to the first vertical voltage line (VVAL(R)).

16. The display panel of claim 15, further comprising a connection electrode (1680') located above the bridge portion (HVAL-B) and below the first vertical voltage line (VVAL(R)),
wherein the bridge portion (HVAL-B) and the first vertical voltage line (VVAL(R)) are electrically connected to each other through the connection electrode (1680').

17. The display panel of any one of the preceding claims **14** to 16, wherein the first horizontal voltage line (HVAL(R)) is electrically connected to the first vertical voltage line (VVAL(R)) through a bridge portion that is located at a layer different from that of the first horizontal voltage line (HVAL(R)).

18. The display panel of any one of the preceding claims 1 to 17, wherein each of the first pixel circuit (PC1) and the second pixel circuit (PC2) further comprises a data write transistor (T2) electrically connected to the driving transistor (T1) and the first capacitor (Cst), and
wherein, in the plan view, a first data line (DL1) electrically connected to the data write transistor (T2) of the first pixel circuit (PC1) and a second data line (DL2) electrically connected to the data write transistor (T2) of the second pixel circuit (PC2) have different shapes from each other.

19. An electronic apparatus comprising a display panel according to any one of the preceding claims 1 to 18.
